# EUROPÄISCHE PATENTSCHRIFT

(11) **EP 0 781 216 B1**
(45) Veröffentlichungstag und Bekanntmachung des Hinweises auf die Patenterteilung: **14.07.1999**
(21) Anmeldenummer: 95930399.1
(22) Anmeldetag: 15.09.1995
(51) Int. Cl.: B60R 21/00

(54) **ELEKTRONISCHE SICHERHEITSEINRICHTUNG FÜR FAHRZEUGINSASSEN**
ELECTRONIC SAFETY DEVICE FOR MOTOR VEHICLE PASSENGERS
DISPOSITIF ELECTRONIQUE DE SECURITE POUR PASSAGERS DE VEHICULES

(30) Priorität: 24.09.1994 DE 4434204; 30.12.1994 DE 4447174
(43) Veröffentlichungstag der Anmeldung: 02.07.1997
(73) Patentinhaber: ROBERT BOSCH GMBH, 70442 Stuttgart (DE)
(72) Erfinder: MATTES, Bernhard, D-74343 Sachsenheim (DE); NITSCHKE, Werner, D-71254 Ditzingen (DE); SCHUMACHER, Hartmut, D-71691 Freiberg (DE); OSWALD, Klaus, D-73666 Baltmannsweiler (DE); CRISPIN, Norbert, D-71638 Ludwigsburg (DE); WEBER, Werner, D-71665 Vaihingen (DE)
(86) Internationale Anmeldenummer: DE9501271
(87) Internationale Veröffentlichungsnummer: WO9609191

(56) Entgegenhaltungen:
- EP-A- 0 174 473
- EP-A- 0 344 788
- DE-A- 4 304 847
- US-A- 4 987 316

## Beschreibung

### Stand der Technik

Die Erfindung betrifft eine elektronische Sicherheitseinrichtung für Fahrzeuginsassen nach dem Oberbegriff des Anspruchs 1. Eine elektronische Sicherheitseinrichtung für Fahrzeuginsassen ist beispielsweise aus dem Zeitschriftenartikel 1141 Ingenieur de l'Automobile (1982) No. 6, Seiten 69 bis 77 bekannt. Derartige Sicherheitseinrichtungen müssen ständig funktionsbereit sein, um im Falle eines schweren Unfalles das Leben von Fahrzeuginsassen schützen zu können. Diese ständige Funktionsbereitschaft muß durch geeignete Prüfungsverfahren, die möglichst viele Bauteile der Sicherheitseinrichtung einschließen, ständig überwacht werden.

Aus EP 0 284 728 ist eine Sicherheitseinrichtung für Fahrzeuginsassen bekannt, die mehrere Sicherungsmittel für Fahrzeugsinsassen, wie Airbag, Gurtstraffer und/oder dergleichen und mehrere Zündpillen zum Auslösen jedes dieser Sicherungsmittel umfaßt. Um den Stromfluß durch jede dieser Zündpillen zu begrenzen, der aus einer begrenzten Energiereserve zur Verfügung gestellt wird, ist zu jeder Zündpille ein Kondensator in Serie geschaltet. Dieser Kondensator läßt nur solange einen Stromfluß durch die Zündpille zu, bis er auf das Spannungsniveau der Energiereserve aufgeladen ist.

Aus der auf die Anmelderin zurückgehenden US-PS 5,146,104 ist weiter eine elektronische Sicherheitseinrichtung für Fahrzeuginsassen bekannt, die ebenfalls einen in Serie zu einer Zündpille geschalteten Kondensator aufweist. Dieser Kondensator hat jedoch einen derart kleinen Kapazitätswert, daß die bei Maximalspannung in ihm befindliche Ladungsmenge nicht zur Zündung der Zündpille ausreicht. Zur Zündung der Zündpille bedarf es vielmehr eines höheren Stroms, der erst durch mehrfaches Auf- und Entladen bzw. Umladen des in Serie zu der Zündpille geschalteten Kondensators durch die Zündpille getrieben wird. Eine Sicherheitseinrichtung der zuletzt beschriebenen Art ist besonders gefeit gegen ungewollte Fehlauslösungen, da ein einmaliger Stromfluß mit der in dem Kondensator befindlichen Ladungsmenge nicht zur Zündung der Zündpille ausreicht. Darüberhinaus ist es auch noch möglich, einen bereits schon eingeleiteten Zündvorgang der Zündpille wieder abzubrechen, wenn sich beispielsweise herausstellt, daß wegen eines vergleichsweise geringen Unfallrisikos der Airbag doch nicht hätte ausgelöst werden müssen.

Aus dem Dokument US-A-4 987 316 ist eine gattungsbildende elektronische Sicherheitseinrichtung für Fahrzeuginsassen mit einem beschleunigungsempfindlichen Sensor, mit einem einen Mikrorechner umfassenden Steuergerät, mit einem Rückhaltemittel und einer dieses Rückhaltemittel steuernden Endstufe, die eine Zündpille umfaßt, bekannt. Das Dokument beschreibt ferner, daß die elektronische Sicherheitseinrichtung Speichermittel umfaßt, in denen Fehlerzustände der Sicherheitseinrichtung und diesen Fehlerzuständen zugeordneten Steueranweisungen abgespeichert sind, die eine erfolgreiche Aktivierung des Rückhaltemittels auch bei Auftreten von Fehlerzuständen ermöglichen.

Aus dem Dokument EP-A-0 174 473 ist weiter eine in integrierter Technik hergestellte Leistungsendstufe bekannt.

### Vorteile der Erfindung

Die erfindungsgemäße Lösung gemäß den Merkmalen des Anspruchs 1 ermöglicht eine besonders effektive Überwachung der Sicherheitseinrichtung und kann dadurch eine hohe Betriebsbereitschaft sicherstellen. Eine besonders schnelle Diagnosefähigkeit und eine trotz Fehlererkennung dennoch mögliche Aktivierung des Sicherungsmittels wie Airbag und/oder Gurtstraffer wird insbesondere dadurch erreicht, daß charakteristische Fehlermerkmale in einer Tabelle abgespeichert werden, und zwar zusammen mit Steueranweisungen, die trotz des Auftretens eines bestimmten Fehlers dennoch eine zuverlässige Auslösung des Airbags sicherstellen.

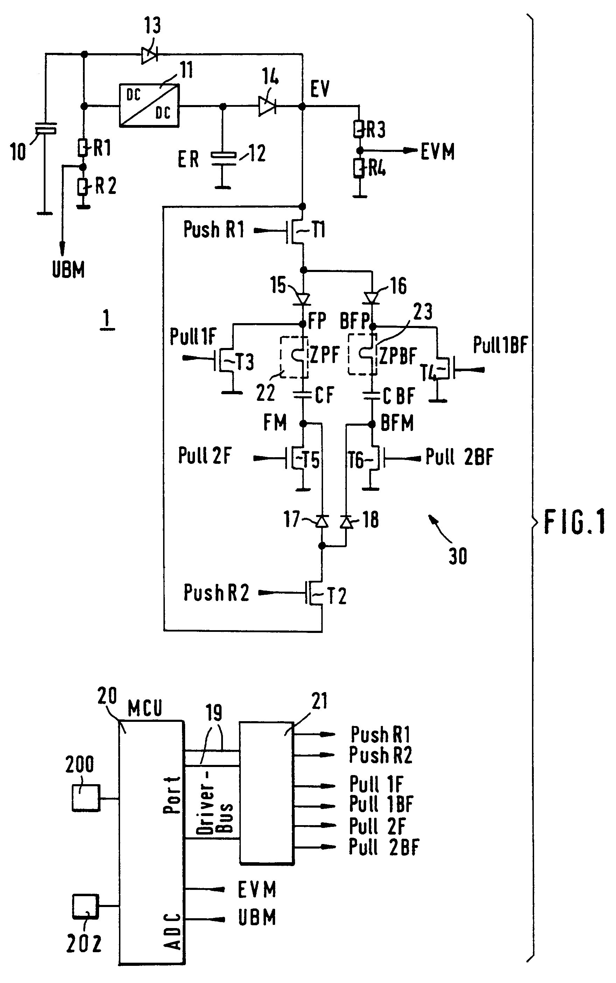

Durch die Ausgestaltung einer Sicherheitseinrichtung gemäß Blockschaltbild nach Figur 1 wird die Verfügbarkeit eines Airbagsystems auch bei einer Vielzahl von schwierigen Fehlerzuständen erheblich gesteigert, was zur Folge hat, daß auch unter sehr ungünstigen Betriebsbedingungen immer noch eine sichere Auslösung des Airbags erreichbar ist. So können beispielsweise Kurzschlüsse nach Fahrzeugmasse bzw. zu dem positiven Anschluß der Spannungsversorgung nicht das korrekte Zünden der Zündpillen verhindern. Durch die aufgrund der Schaltungsauslegung ermöglichte Betriebsweise der Schaltelemente T1, T2 und T3, T4 bzw. T5, T6 im Gegentaktbetrieb kann auch bei vergleichsweise kleiner zur Verfügung stehender Versorgungsspannung noch ein ausreichend hoher Spannungshub an den Zündkreiskondensatoren CF, CBF erzielt werden. Dadurch ist eine sichere Aktivierung des Sicherungsmittels Airbag auch noch bei der vergleichsweise geringen Batteriespannung zwischen 9 Volt und 16 Volt ohne weiteres möglich. Weiterhin ist es möglich, Sicherungseinrichtungen auch ohne zusätzliche Energiereserve und ohne zusätzlichen Spannungswandler zu konstruieren, wenn dies aus Kostengründen gefordert wird. Durch Erfassung der Versorgungsspannung EV zum Beispiel vor Beginn eines Zündvorganges und gegebenenfalls in weiteren zweckmäßigen Zeitabständen während eines laufenden Zündvorganges, zum Beispiel im Abstand von jeweils einer Millisekunde, läßt sich auf besonders vorteilhafte Weise auch noch die Ansteuerung der Schaltelemente den dann jeweils vorliegenden aktuellen Gegebenheiten anpassen. D.h. man erzielt dadurch eine Beaufschlagung der Zündpille mit einem weitgehend konstanten Zündstrom, wodurch die Sicherheit gegen Fehlauslösungen wesentlich erhöht wird. Da nämlich der mittlere Zündstrom durch die Zündpille pro Arbeitstakt T auf einen günstigen mittleren Wert von ungefähr 2 Ampere gehalten werden kann, kommt es selbst dann noch nicht zu einer unerwünschten Auslösung, wenn eine Zündpille fälschlicherweise mit bis zu 20 Taktzyklen angesteuert wird. Andererseits ermöglicht die vorgeschlagene Sicherheitseinrichtung aber auch einen extrem verschwenderischen Umgang mit Zündenergie, um bei bestimmten Fehlerzuständen eine Ansteuerung der Zündpille und eine sichere Auslösung des Airbags mit Gewalt zu erzwingen. Dies ist insbesondere bei Kurzschlüssen der Zündpille der Fall, bei denen man noch versucht, Nebenschlüsse in der Größenordnung von etwa 0,5 Ohm bis 1 Ohm abzufangen, um der Zündpille dennoch genügend Zündenergie zuzuführen. In diesem Fehlerfall ermöglicht die vorgeschlagene Schaltungsauslegung durch die entsprechend geeignete Betriebsart eine erhebliche Vergrößerung des Stromdurchsatzes, um die Zündung dennoch herbeizuführen. Einen weiteren Sonderfall stellt auch die Zündkreisunterbrechung dar, die bei einem Widerstand von etwa 10 Ohm angenommen wird. Hierbei ist es sinnvoll, frühzeitig durch geeignete Betriebsweise einen genügend hohen Spannungshub an den Kondensatoren CF, CBF des Zündkreises zu bewirken, um eine sichere Auslösung zu erzielen. Zur Erfassung des aktuellen Fehlerzustandes der Sicherheitseinrichtung selbst noch im Auslösezeitpunkt kann durch die Auswahl einer geeigneten Steuerstrategie die günstigste Betriebsart ausgewählt werden, um die der vorhandenen Situation entsprechende günstigste Auslösewirkung zu erreichen. Besonders vorteilhaft ist weiter, daß eine bereits ausgewählte Steuerstrategie erforderlichenfalls noch überprüfbar ist und beispielsweise wieder abgeändert werden kann, wenn sich eine andere Steuerstrategie als günstiger erweisen sollte. Beispielsweise kann nach Auswahl einer bestimmten Steuerstrategie in einem Abstand von etwa 1 Millisekunde überprüft werden, ob eine für eine festgestellte Fehlersituation ausgewählte Steuerstrategie optimal geeignet ist oder nicht. Bei Nichteignung kann noch vor Ablauf des nächsten Arbeitstaktes gegebenenfalls auf eine besser angepaßte Steuerstrategie umgeschaltet werden. Demzufolge ermöglicht die erfindungsgemäße Sicherheitseinrichtung die optimale Ausnutzung von Zündenergie, was von besonderer Wichtigkeit ist, wenn die Fahrzeugbatterie bereits abgerissen ist und nur noch die außerordentlich begrenzte Energiereserve zur Verfügung steht. Ferner ergibt sich der außerordentliche Vorteil, daß selbst bei sogenannten Doppelfehlern im Bereich der Zündkreise die Möglichkeit besteht, für eine bestimmte Zeitdauer des Auslösevorgangs eine optimale Steuerstrategie für die Kompensation des ersten Fehlers und während einer weiteren Zeitdauer des Auslösevorgangs eine optimale Steuerstrategie für die Kompensation des zweiten Fehlers einzusetzen. Beispielsweise kann eine erste Strategie für eine Zeitdauer von etwa 1 Millisekunde zur Behebung eines ersten Fehlerzustandes und eine weitere Steuerstrategie für eine Zeitdauer von einer weiteren Millisekunde für die Behebung eines zweiten Fehlerzustandes eingesetzt werden.

In einer besonders vorteilhaften Ausgestaltung der Erfindung können, durch regelmäßige Überprüfung der Sicherheitseinrichtung erkannte Fehlerzustände auch in einem Speicherbereich des Mikrocontrollers abgespeichert werden. Falls dann zeitlich später, im Zusammenhang mit einer Unfallsituation, eine Auslösung der Sicherungsmittel erforderlich wird, können diese abgespeicherten Fehlerzustände wieder aufgerufen und bei der Auswahl der geeigneten Steuerstrategie zur Ansteuerung der Zündpillen noch mit berücksichtigt werden. So könnte beispielsweise ein während des Auslösevorgangs akut auftretender Fehler dazu führen, daR zunächst, beispielsweise für eine Zeitdauer von etwa 4 Millisekunden, eine erste Steuerstrategie ausgewählt wird, die den akut auftretenden Fehlerzustand kompensiert; in einem nachfolgenden Zeitintervall könnte dann eine abweichende Steuerstrategie gewählt werden, die auch noch die früher abgespeicherten Fehlerzustände berücksichtigt.

### Zeichnung

Ausführungsbeispiele der Erfindung sind in der Zeichnung dargestellt und in der nachfolgenden Beschreibung näher erläutert. Es zeigen Figur 1 ein Blockschaltbild der erfindungsgemäßen Sicherheitseinrichtung, Figur 2 eine Tabelle mit Fehlerzuständen und fehlerabhängigen Steueranweisungen, Figur 3 bis Figur 7 Funktionsdiagramme zur Erläuterung bestimmter Fehlerzustände und daraus resultierender Steuervorgänge, Figur 8 ein Ablaufdiagramm zur Erläuterung der Fehlererkennung und der sich aus der Fehlererkennung ergebenden Steuerung der Airbagauslösung, Figur 9 als Blockschaltbild, eine Sicherheitseinrichtung mit einer Vielzahl von Rückhaltemitteln und diesen zugeordneten Endstufen, Figur 10 ein erstes Ausführungsbeispiel einer in integrierter Technik ausgeführten Endstufe, bei der die Zündpille in einer Vollbrückenschaltung angeordnet ist, Figur 11 ein zweites Ausführungsbeispiel einer in integrierter Technik ausgeführten Endstufe, bei der die Zündpille in einer 3/4-Brücke angeordnet ist, Figur 12 ein drittes Ausführungsbeispiel einer in integrierter Technik ausgeführten Endstufe mit einer in einer 1/2-Brücke angeordneten Zündpille, Figur 13 ein dazu gehörendes Funktionsdiagramm, Figur 14 bis 16 weitere Ausführungsbeispiele mit einem Referenzweig.

### Beschreibung der Ausführungsbeispiele

In Figur 1 ist ein Blockschaltbild der erfindungsgemäßen Sicherheitseinrichtung für Fahrzeuginsassen dargestellt. Sie ist in einem Fahrzeug, vorzugsweise in einem Landfahrzeug, wie einem Personenkraftwagen oder Lastkraftwagen angeordnet und dient zum Schutz der Insassen bei schweren Unfällen durch Aktivierung eines Sicherungsmittels wie Airbag und/oder Gurtstraffer oder dergleichen. Die Sicherheitseinrichtung ist mit der Batterie 10 des Kraftfahrzeuges verbunden, von der sie mit Strom versorgt wird. Parallel zu der Batterie 10 ist eine die Widerstände R1, R2 umfassender Spannungsteiler geschaltet. Der Abgriff des Spannungsteilers R1, R2 ist über eine Leitung UBM mit einem Eingangsanschluß (Analog/Digital-Eingang) eines Mikrorechners 20 verbunden. Über diese Leitung UBM kann an dem Spannungsteiler R1, R2 ein Spannungswert zwecks Kontrolle der Spannung der Fahrzeugbatterie 10 abgegriffen werden. Üblicherweise ist die Fahrzeugbatterie 10 mit ihrem negativen Anschluß mit dem Masseanschluß des Fahrzeugs verbunden. An den positiven Anschluß der Fahrzeugbatterie 10 ist ein Eingangsanschluß eines Gleichspannungswandlers 11 angeschlossen, dessen Ausgangsanschluß mit dem positiven Anschluß einer Energiereserve 12 verbunden ist, deren negativer Anschluß ebenfalls mit dem Masseanschluß verbunden ist. Als Energiereserve 12 eignet sich ein Kondensator vergleichsweise großer Kapazität, zum Beispiel einige Tausend Mikrofarad. Diese Energiereserve 12 ist für den Fall vorgesehen, daß die elektronische Sicherheitseinrichtung auch dann noch zumindest für eine begrenzte Zeit mit Strom versorgt wird und funktionsfähig bleibt, wenn bei einem Unfall die Verbindung zu der Fahrzeugbatterie 10 unterbrochen wird. Zweckmäßigerweise wird die Energiereserve 12 vermittels des Gleichspannungswandlers 11 auf eine Spannung aufgeladen, die ein Mehrfaches der Spannung der Fahrzeugbatterie 10 beträgt. Wenn beispielsweise das Bordnetz des Fahrzeugs für etwa 12 Volt Gleichspannung ausgelegt ist, wird die Energiereserve 12 beispielsweise auf einen Spannungswert von 45 bis 50 Volt aufgeladen. Der positive Anschluß der Fahrzeugbatterie 10 ist ebenfalls wie der positive Anschluß der Energiereserve 12 über eine in Flußrichtung gepolte Diode 13, 14 mit dem Hochpunkt eines zweiten Spannungsteilers R3, R4 verbunden, dessen Fußpunkt ebenfalls auf Masse liegt. Der Abgriff des Spannungsteilers R3, R4 ist über eine Leitung EVM mit einem zweiten Eingangsanschluß (Analog/Digital-Wandlung) des Mikrocontrollers 20 verbunden. Über diese Leitung EVM kann zwecks Kontrolle der an dem Spannungsteiler R3, R4 anliegenden Spannung eine Teilspannung abgegriffen werden. An dem Verbindungspunkt der Dioden 13, 14 sind erste Schaltanschlüsse je eines Schaltelements T1, T2 angeschlossen, deren jeweils zweiter Schaltanschluß an die miteinander verbundenen Anodenanschlüsse von jeweils zwei Dioden 15, 16 bzw. 17, 18 geführt ist. Zwischen die Kathodenanschlüsse der Dioden 15, 17 sind in Serie hintereinander eine erste Zündpille ZPF (beispielsweise für den Fahrerairbag) und ein erster Kondensator CF geschaltet. Zwischen die Kathodenanschlüsse der Dioden 16, 18 ist eine zweite Zündpille ZPBF (z.B. für den Beifahrer) und ein zweiter Kondensator CBF in Serie eingeschaltet. An den Verbindungspunkt zwischen dem Kathodenanschluß der Diode 15 und der Zündpille ZPF ist ein erster Schaltanschluß eines weiteren Schaltelements T3 angeschlossen, dessen zweiter Schaltanschluß auf Masse gelegt ist. An den Verbindungspunkt zwischen den Kathodenanschluß der Diode 17 und des Kondensators CF ist ebenfalls ein erster Schaltanschluß eines weiteren Schaltelements T5 angeschlossen, dessen zweiter Schaltanschluß ebenfalls mit Masse verbunden ist. An den Verbindungspunkt zwischen dem Kathodenanschluß der Diode 16 und der Zündpille ZBPF ist ein erster Schaltanschluß eines Schaltelements T4 angeschlossen, dessen zweiter Schaltanschluß auf Masse liegt. Weiterhin ist an den Verbindungspunkt zwischen dem Kathodenanschluß der Diode 18 und dem Kondensator CBF ein erster Schaltanschluß des Schaltelements T6 angeschlossen, dessen zweiter Schaltanschluß auf Masse liegt. Die Steueranschlüsse aller Schaltelemente T1, T2, T3, T4, T5, T6 sind über Leitungsverbindungen PushR1, PushR2, Pull1F, Pull1BF, Pull2F und Pull2BF mit entsprechend bezeichneten Ausgangsanschlüssen einer Treiberschaltung 21 verbunden, die über entsprechende Busleitungen 19 mit Ausgangsanschlüssen des Mikrocontrollers 20 verbunden sind und von diesem angesteuert werden. Die Zündpillen ZPF, ZPBF stehen in thermischer Wirkverbindung mit nicht im einzelnen dargestellten Treibladungen der als Sicherungsmittel für Fahrzeuginsassen vorgesehenen Airbags 22, 23. Thermische Wirkverbindung bedeutet in diesem Zusammenhang, daß die Zündpillen ZPF, ZPBF, die durch Stromdurchgang aufheizbar sind, in erhitztem Zustand eine Treibladung zu aktivieren vermögen, die die Airbags 22, 23 aufbläst.

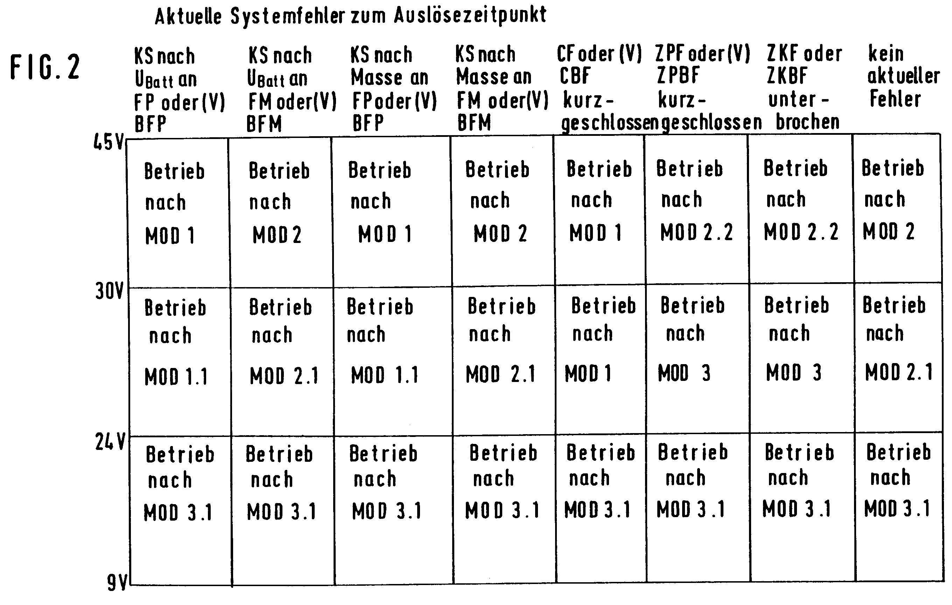

Die Funktionsweise der in Figur 1 als Blockschaltbild dargestellten Sicherheitseinrichtung wird im folgenden unter Bezug auf die weiteren Figuren erläutert. In Figur 2 sind zunächst in Gestalt einer Tabelle mögliche Fehlerzustände der Sicherheitseinrichtung und fehlerabhängige Steueranweisungen dargestellt, durch die trotz des Fehlerzustandes noch eine sichere Auslösung der Airbags 22, 23 erreicht werden soll. Fehlerzustände und fehlerabhängige Steueranweisungen sind zweckmäßig in Speichermitteln 202 abgespeichert, die auch Bestandteil des Mikrorechners 20 sein können. Die diversen Fehlerzustände sind in der ersten Zeile der Tabelle aufgelistet. Im einzelnen handelt es sich dabei um folgende Fehlerzustände:
- Kurzschluß (KS) zum positiven Anschluß der Fahrzeugbatterie 10 bzw. der Energiereserve 12 an den Schaltungspunkten FP oder BFP;
- Kurzschluß zu dem positiven Anschluß der Fahrzeugbatterie 10 oder der Energiereserve 12 an den Schaltungspunkten FM oder BFM;
- Kurzschluß nach Masse in den Schaltungspunkten FP oder BFP;
- Kurzschluß nach Masse in den Schaltungspunkten FM oder BFM;
- Kurzschluß der Kondensatoren CF bzw. CBF;
- Kurzschluß der Zündpillen ZBF oder ZPBF;
- Unterbrechung von ZKF oder ZKBF;
- kein aktueller Fehler.

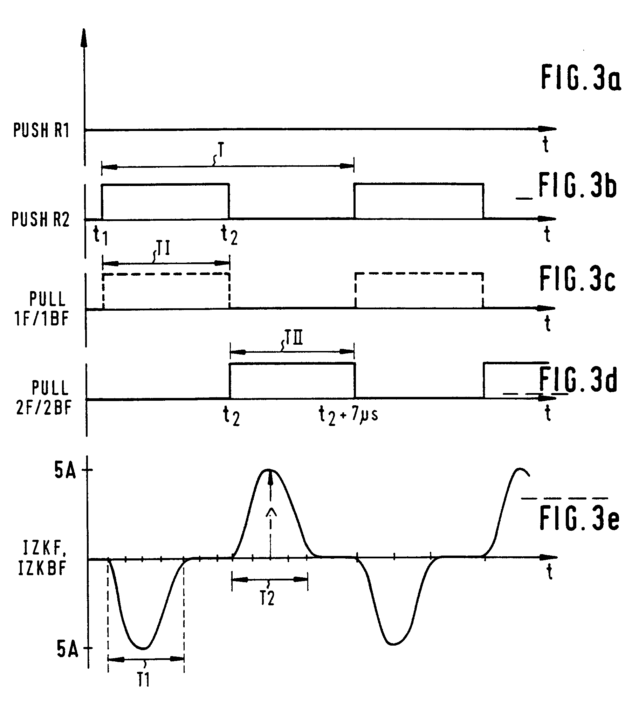

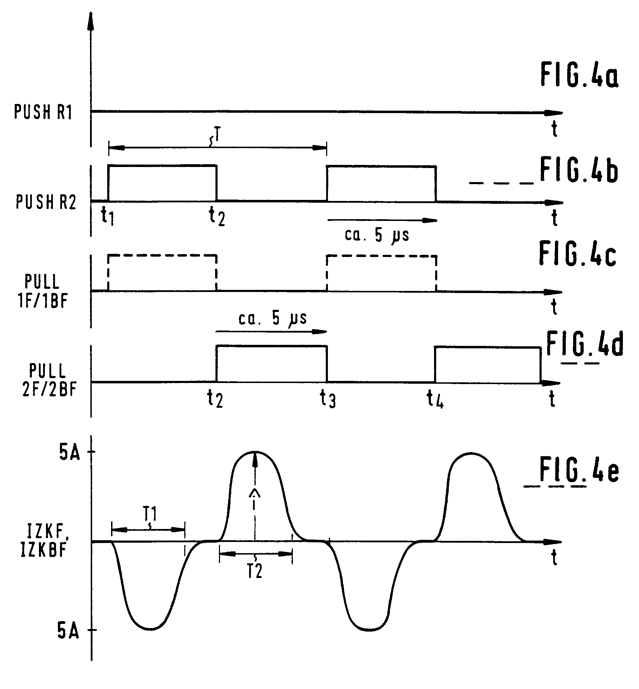

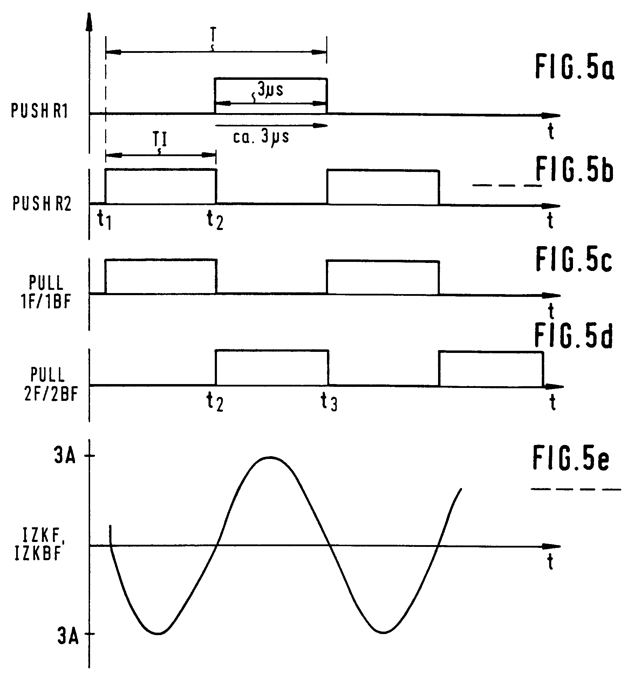

In den darunterliegenden drei Zeilen sind jedem Fehlerzustand zugeordnete Steueranweisungen aufgelistet, die jeweils noch von der aktuell zur Verfügung stehenden Versorgungsspannung EV abhängig sind, also beispielsweise davon, ob die Versorgungsspannung zwischen 9 und 24 Volt, zwischen 24 und 30 Volt, oder zwischen 30 und 45 Volt liegt. Es handelt sich praktisch um ein von den Eingangsparametern Fehlerzustand und Höhe der Versorgungsspannung EV abhängiges Kennfeld, das sowohl eine extrem schnelle Fehlerdiagnose als auch eine äußerst effektive, von Fehlerzustand und Höhe der Versorgungsspannung abhängige Ansteuerung der Zündpillen ZPF, ZPBF und damit Aktivierung der Airbags 22 und 23 ermöglicht. Zur Erläuterung werden beispielsweise zwei Matrixfelder der Tabelle gemäß Figur 2 herausgegriffen. Beispielsweise werde ein Kurzschluß zum positiven Pol der Fahrzeugbatterie 10 bzw. der Energiereserve 12 am Schaltungspunkt FP oder BFP festgestellt (siehe Fehlerzustand in Spalte 1, Zeile 1 der Tabelle). Je nach aktuell vorhandener Höhe der Versorgungsspannung EV werden dann unterschiedliche Steuerstrategien verfolgt, um trotz des erkannten Fehlerzustandes dennoch zu einer hinreichenden Beaufschlagung der Zündpillen ZPF, ZPBF mit Zündstrom zu gelangen, um die Airbags 22, 23 mit Sicherheit auszulösen. Im Spannungsbereich der Versorgungsspannung EV zwischen 9 Volt und 24 Volt wird beispielsweise eine Steuerstrategie MOD 3.1. verfolgt (vgl. Spalte 1, Zeile 4 der Tabelle in Figur 2) die später noch anhand von Figur 5 näher erläutert wird. Bei einem Spannungsbereich der Versorgungsspannung EV zwischen 24 Volt und 30 Volt und dem zuvor beschriebenen Fehlerzustand wird dagegen eine Steuerstrategie MOD 1.1 verfolgt (vgl. Spalte 1, Zeile 3 der Tabelle gemäß Figur 2), die später noch unter Bezug auf Figur 4 näher erläutert wird. Schließlich wird bei einer Versorgungsspannung zwischen 30 und 45 Volt und dem zuvor beschriebenen Fehlerzustand eine Steuerstrategie nach MOD 1 verfolgt (Spalte 1, Zeile 2 der Tabelle nach Figur 2), die später noch anhand von Figur 3 näher erläutert wird. Entsprechendes gilt für die anderen Positionen der in Figur 2 dargestellten Tabelle, die im folgenden jeweils noch weiter erläutert werden.

Unter Bezug auf Figur 3 wird zunächst die Steuerstrategie MOD 1 näher erläutert, die gemäß Tabelle in Figur 2 dann Anwendung findet, wenn ein Kurzschluß zum positiven Anschluß der Fahrzeugbatterie 10 bzw. der Energiereserve 12 an den Punkten FP oder BFP des Blockschaltbildes gemäß Figur 1 erkannt wird und gleichzeitig eine Höhe der Versorgungsspannung EV im Bereich zwischen 30 Volt und 45 Volt festgestellt wird (vgl. Position Spalte 1, Zeile 2 der Tabelle gem. Figur 2). Die gleiche Steuerstrategie findet gemäß Tabelle der Figur 2 (vgl. dort Position Spalte 3, Zeile 2 und Spalte 5, Zeile 2) dann Anwendung, wenn ein Kurzschluß nach Masse an den Schaltungspunkten FP oder BFP bzw. ein Kurzschluß der Kondensatoren CF oder CBF festgestellt wird.

Die Steuerstrategie gemäß MOD 1 (vgl. Figur 3) ist dann besonders günstig, wenn ein Kurzschluß zwischen den Schaltungspunkten FP, BFP zum positiven Pol der Spannungsversorgung vorliegt. Dabei werden sowohl die Fehlerzustände abgedeckt, bei denen entweder der Kurzschluß zwischen den Schaltungspunkten FP oder BFP besteht oder beide erwähnten Schaltungspunkte zum Pluspol der Versorgungsspannung kurzgeschlossen sind. In diesen Fällen ist der Spannungshub der in den Zündkreisen liegenden Kondensatoren CF, CBF unabhängig von der Höhe der Spannung der Fahrzeugbatterie 10. Dadurch wird die Dauer des Stromflusses durch die Zündpillen ZPF, ZPBF nicht durch den Fehlerkurzschluß zu dem positiven Anschluß der Spannungsversorgung beeinflußt. Hierdurch ergibt sich demzufolge keine Änderung der Auslöseverzugszeit der Airbags 22, 23 aufgrund einer Anderung des Stromdurchsatzes durch die Zündpillen ZPF, ZPBF, verursacht durch den Kurzschluß nach dem positiven Pol der Versorgungsspannung, im Vergleich zu einem fehlerfreien Zündkreis. In dem Funktionsdiagramm nach Figur 3 sind die wesentlichen Signalverläufe dargestellt, die bei der Steuerstrategie MOD 1 von Bedeutung sind. Bei dieser Darstellung wurde eine minimale Zündkreisinduktivität von ca. 2 Mikrohenry angenommen. Zunächst werden durch das leitend gesteuerte Schaltelement T2 (Steuerleitung PushR2), die in den Zündkreisen angeordneten Kondensatoren CF, CBF gegen einen eventuell an den Schaltungspunkten FP oder BFP vorhandenen Kurzschluß zum positiven Anschluß der Spannungsversorgung geladen, wobei zusätzlich die Schaltelemente T3, T4 leitend gesteuert werden können (Steuerleitungen Pull1F, Pull1BF), um gegen einen Kurzschluß zum positiven Spannungsanschluß anzukämpfen bzw. um denjenigen Schaltungspunkt FP oder BFP, an dem kein Kurzschluß vorliegt, definiert auf Masse zu legen. Dadurch werden auch Kurzschlußsituationen beherrschbar, die über Dioden eingekoppelt werden. Aus Figur 3b ist ersichtlich, daß die Ansteuerung des Schaltelements T2 taktweise erfolgt und beispielsweise zum Zeitpunkt t1 auf der Zeitachse t beginnt. Das Schaltelement T2 ist dann für einen Zeitraum von rund 7 Mikrosekunden leitend gesteuert. Im Anschluß daran ist das Schaltelement T2, wie sich aus Figur 3b ergibt, für einen Zeitraum von 7 Mikrosekunden wieder gesperrt um dann erneut für rund 7 Mikrosekunden leitend gesteuert zu werden. Die jeweils leitend gesteuerten Zeitphasen folgen in einem Zeitabstand von T. Wie bereits zuvor erwähnt, können gemäß Figur 3c auch zusätzlich noch die Schaltelemente T3, T4, jeweils in der Leitphase des Schaltelements T2 auch leitend gesteuert werden. Danach werden die Schaltelemente T2 (gegebenenfalls auch T3, T4) durch entsprechende Ansteuerung auf den zugeordneten Steuerleitungen PushR2, Pull1F, Pull1BF gesperrt und die Schaltelemente T5, T6 (vgl. Figur 3d) leitend gesteuert. Die leitende Phase der Schaltelemente T5, T6 beginnt zum Zeitpunkt t2 und dauert ebenfalls rund sieben Mikrosekunden an. Durch diesen Steuervorgang werden die in den Zündkreisen angeordneten Kondensatoren CF, CBF in umgekehrter Richtung geladen. In Figur 3e sind die Stromimpulse IZKF, IZKBF als Funktion der Zeit dargestellt, die sich durch die zuvor beschriebene Ansteuerung der Zündkreise ergeben und die Zündpillen ZPF bzw. ZPBF beaufschlagen. Da hinreichend bekannt ist, welche Energiemenge zur sicheren Aktivierung einer Zündpille notwendig ist, kann auf einfache Weise festgestellt werden, wieviel derartiger Stromimpulse erforderlich sind, um die Zündpillen zu aktivieren.

Unter Bezugnahme auf Figur 4 wird jetzt der Steuermodus MOD 1.1 beschrieben, der gemäß Tabelle von Figur 2 dann Anwendung findet, wenn beispielsweise ein Kurzschluß zum positiven Pol der Versorgungsspannung an den Schaltungspunkten FP oder BFP (Spalte 1, Zeile 3 der Tabelle) bzw. ein Kurzschluß nach Masse an den Schaltungspunkten FP oder BFP (Spalte 3, Zeile 3 der Tabelle) vorliegt. Die Betriebsweise gemäß MOD 1.1 berücksichtigt die Abnahme der Versorgungsspannung auf einen zwischen 24 und 30 Volt liegenden Wert. Durch diesen Parameter läßt sich die Ansteuerung der Zündpillen derart einstellen, daß der Stromdurchsatz durch die Zündpillen in einem genau spezifizierten Bereich gehalten werden kann. Soweit bekannt, wird hiermit erstmalig eine Art Pulsweitenmodulation zur Steuerung des Stromdurchsatzes bei Zündpillen in einem Airbagsteuergerät vorgeschlagen, wobei noch während des Unfallvorgangs und während des Zündvorgangs der Zündpillen der aktuelle Wert der Versorgungsspannung berücksichtigt wird. Ein weiteres Eingehen auf die in Figur 4 dargestellten Signaldiagramme erübrigt sich, da diese, bis auf geringfügig andere Ansteuerungszeiten, im wesentlichen den bereits ausführlich besprochenen Signalverläufen nach Figur 3 entsprechen. Die Schaltelemente T1 bis T6 werden sowohl bei MOD 1 als auch MOD 1.1 derart angesteuert, daß maximal rund 5 Ampere Strom (IZKF, IZKBF) fließen kann, wenn es die Spannungsverhältnisse zulassen. Die Betriebsarten MOD 1 und MOD 1.1 eignen sich ebenfalls für eine Ansteuerung im Falle eines Kurzschlusses der Schaltungspunkte FP oder BFP nach Masse, ohne daß eine Leistungseinbuße eintritt. Außerdem eignen sich die vorerwähnten Betriebsarten auch noch für den Fall des Kurzschlusses der Kondensatoren CF, CBF ohne wesentliche Leistungseinbuße, da dann immer noch rund 2,5 Ampere Zündstrom bereitgestellt werden kann, der für die Aktivierung ausreichend ist.

Anhand von Figur 5 wird nun die Steuerstrategie MOD 3.1. erläutert. Diese Betriebsart berücksichtigt die Abnahme der Versorgungsspannung in dem Spannungsbereich zwischen etwa 9 Volt und 24 Volt. Dieser Zustand tritt beispielsweise bei einer defekten Energiereserve 12 auf oder bei einer zu langen Zeitdauer zwischen dem Abriß der Fahrzeugbatterie 10 und einem nachfolgenden schweren Unfallablauf. Weiterhin kann eine derartige Situation bei Sicherheitseinrichtungen vorliegen, die ohne Energiereserve und Gleichspannungswandler auskommen müssen. In dem ungünstigsten Fall eines vorhandenen Kurzschlusses zu dem positiven Pol der Versorgungsspannung ergeben sich aufgrund des verbleibenden kleinen Spannungshubes von rund 6 Volt an einem betrachteten Kondensator CF, CBF eines jeweiligen Zündkreises unter Berücksichtigung einer Induktivität des Zündkreises von rund 2 Mikrohenry noch durchschnittliche Zündkreisströme in der Größenordnung von rund 2 Ampere. Dies wird durch eine optimale Ansteuerung im Resonanzbereich der Zündkreise und durch die hiermit vorgeschlagene Ansteuerung der Schaltelemente T1, T2 bzw. T3, T4 und T5, T6 im Gegentaktbetrieb ermöglicht. Dadurch kann selbst im ungünstigsten Fall immer noch ein Spannungshub von rund 12 Volt an den Kondensatoren CF, CBF im Zündkreis bereitgestellt werden.

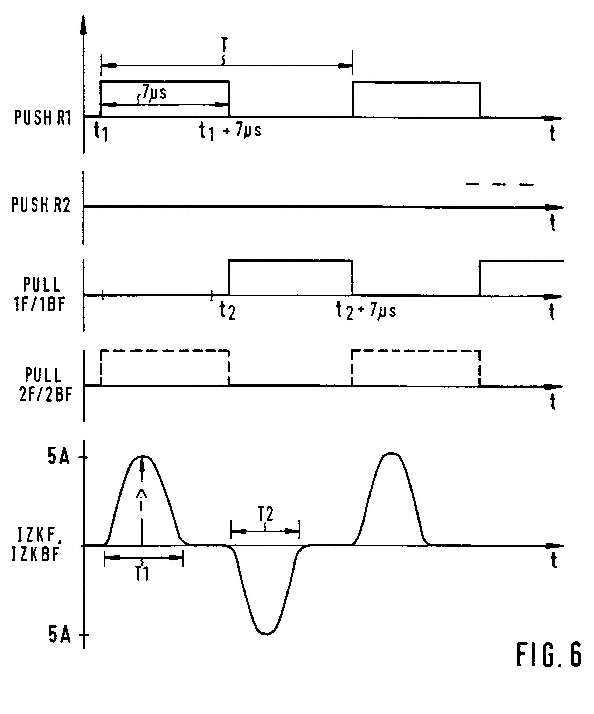

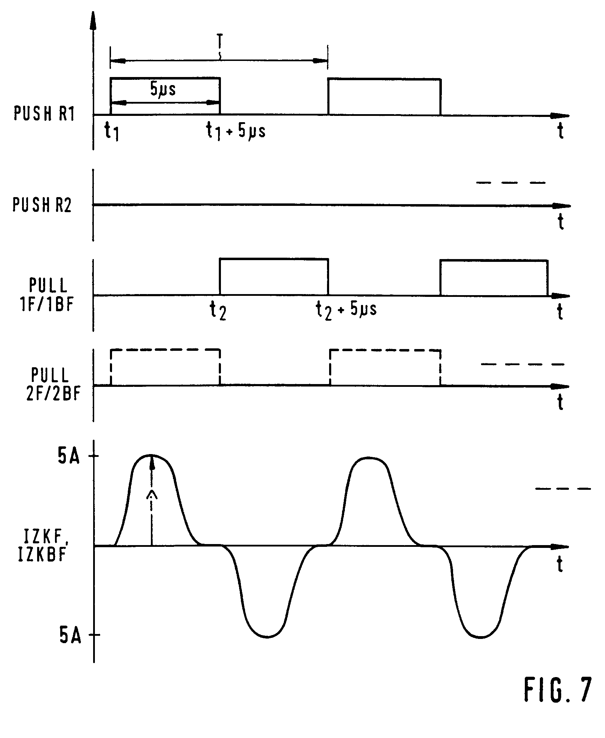

Im folgenden werden unter Bezugnahme auf Figur 6 und Figur 7 die Steuerstrategien MOD 2 und MOD 2.1 näher erläutert. Diese Betriebsweisen haben sich dann als besonders günstig erwiesen, wenn ein Kurzschluß von den Schaltungspunkten FM des Fahrerairbags oder BFM des Beifahrerairbags zum positiven Anschluß der Versorgungsspannung vorliegt (bzw. von beiden). In diesem Fall ist der Spannungshub an den Kondensatoren CF, CBF der Zündkreise ebenfalls unabhängig von der Höhe der Batteriespannung der Fahrzeugbatterie (U_{Bat} ungefähr 9 bis 16 Volt). Dadurch wird die Stromflußdauer durch die Zündpillen ZPF, ZPBF nicht durch den Fehlerkurzschluß zum positiven Pol der Versorgungsspannung beeinflußt. Diese Betriebsarten sind dadurch möglich, daß die in Figur 1 dargestellte Sicherheitseinrichtung zwei getrennt ansteuerbare Schaltelemente T1, T2 in der Zündendstufe aufweist. Eine eingehendere Diskussion der in Figur 6 und Figur 7 dargestellten Kurvenverläufe erübrigt sich, da die schon zu den Betriebsweisen MOD 1 und MOD 1.1 gemachten Ausführungen hier analog gelten. Die Betriebsarten MOD 2 und MOD 2.1 eignen sich ebenfalls besonders gut für eine Steuerung bei der Fehlerart Kurzschluß nach Masse an den Schaltungspunkten FM bzw. BFM, ohne daß dabei ein Leistungsverlust zu beobachten ist. Dasselbe gilt auch für eine Ansteuerung der Zündkreise im Falle der Fehlerfreiheit.

Die Betriebsart MOD 2.2 eignet sich besonders dann gut als Steuerungsstrategie, wenn die Sicherungseinrichtung einen Kurzschluß einer Zündpille ZPF, ZPBF eines Zündkreises erkennt. Hat dieser Kurzschluß noch einen von 0 Ohm unterschiedlichen Wert und liegt beispielsweise im Bereich größer 0 Ohm kleiner 1 Ohm, so kann es sich als zweckmäßig erweisen, durch eine entsprechende Taktsteuerung (Pulsweitenmodulation) die Zündpillen ZPF, ZPBF wenigstens für eine gewisse Zeit mit dem höchstmöglichen Stromdurchsatz zu beaufschlagen. Bei einer angenommenen Zündkreisinduktivität von rund 2 Mikrohenry ist mit einer Ansteuerungsdauer von rund 6 Mikrosekunden der Resonanzpunkt eingestellt. Bei einem Kurzschlußwiderstandswert von ungefähr 0,5 Ohm ergeben sich dabei noch Stromwerte durch die Zündpille von rund 1 Ampere. Die kleinere Versorgungsspannung in der Größenordnung von 24 Volt bis 30 Volt ist bei einer Forderung nach einem hohen Stromdurchsatz durch die Zündpillen für den Fehlerzustand Kurzschluß der Zündpillen (Restwiderstand von ungefähr > 0 Ohm bis < 1 Ohm) anzuwenden. Durch Ansteuerung der beiden Schaltelemente T1, T2 im Gegentaktbetrieb wird der Spannungshub an den Kondensatoren CF, CBF der Zündkreise verdoppelt, so daß der limitierte Maximalstrom fließen kann. Durch Beschränkung des Einsatzes dieser Betriebsart auf niedrigere Versorgungsspannungen treten auch keine übermäßig hohen Sperrspannungen an den Schaltelementen auf, so daß sehr kostengünstige diskrete Halbleiterbauelemente oder auch integrierte Halbleiterbauelemente als Schaltelemente eingesetzt werden können. Die Betriebsart MOD 3 eignet sich ebenfalls auch besonders gut für den Fehlerfall einer Unterbrechung in den Zündkreisen. Dieser Fehlerzustand wird beispielsweise dann angenommen, wenn die Widerstände in dem Zündkreis den Wert von etwa 10 Ohm übersteigen. Bei derart hohen Zündkreiswiderständen ist es sinnvoll, rechtzeitig für einen ausreichenden Spannungshub an den Komponenten der Zündkreise (Zündpille, Kondensator) zu sorgen, damit der Zündstrom auf den minimal erforderlichen Wert von ungefähr 2 Ampere gehalten werden kann. Dies wird durch den Gegentaktbetrieb der Schaltelemente T1, T2 bzw. T3, T4 und T5, T6 erreicht.

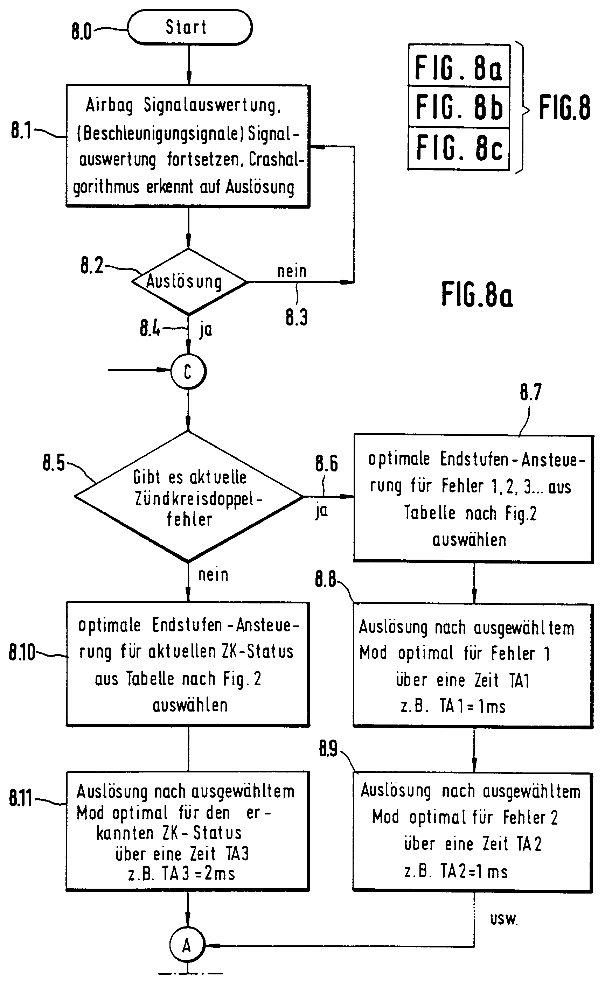

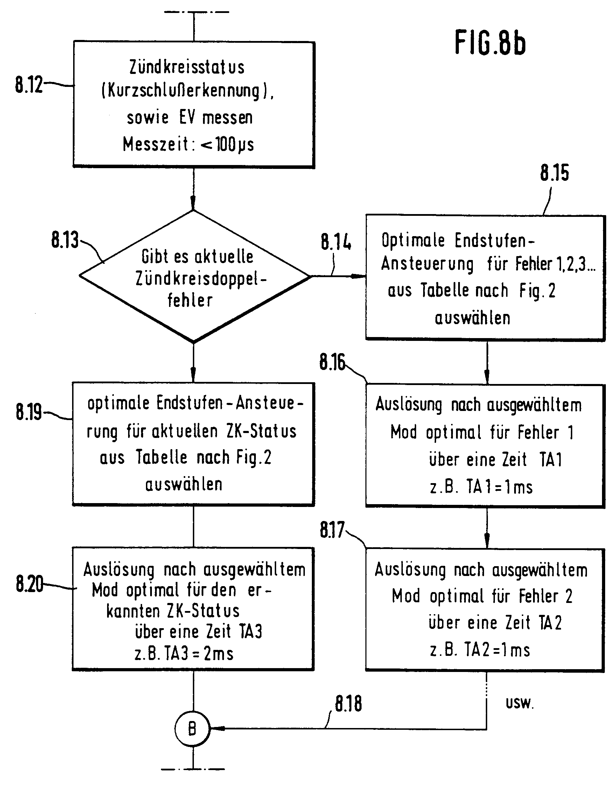

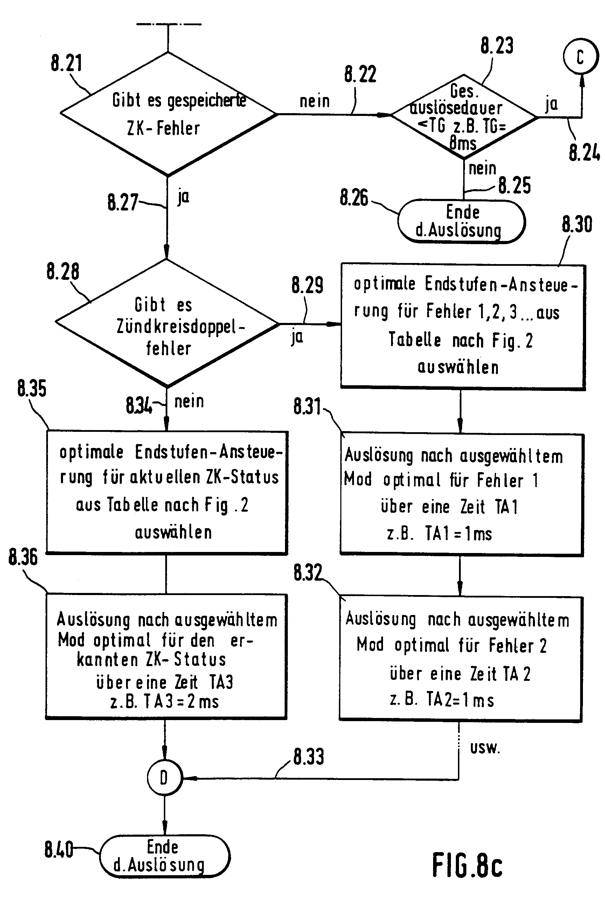

Unter Bezug auf das in Figur 8 dargestellte Ablaufdiagramm wird im folgenden der Ablauf des Betriebs der erfindungsgemäßen Sicherungseinrichtung nochmals erläutert. Es werde angenommen, daß das mit der elektronischen Sicherheitseinrichtung ausgestattete Fahrzeug in den Betriebszustand versetzt worden ist und am Straßenverkehr teilnimmt (Schritt 8.0). In dem Verfahrensschritt 8.1. findet die Signalauswertung statt, d.h., die von einem beschleunigungsempfindlichen Sensor 200 aufgenommenen Signale werden von dem Mikrorechner 20 ausgewertet, wobei festgestellt wird, ob die Signale auf eine schwerwiegende Unfallsituation hindeuten, die eine Auslösung des Airbags 22, 23 notwendig macht (Schritt 8.2). Sollte dies nicht festgestellt werden (8.3) wird die Signalauswertung fortgesetzt (8.1). Wenn eine Unfallsituation erkannt wird (8.4) wird überprüft (8.5), ob aktuelle Zündkreisdoppelfehler vorliegen (8.6) oder nicht.

Falls aktuelle Zündkreisdoppelfehler erkannt werden (8.6) wird eine optimale, fehlerangepaßte Steuerstrategie gemäß Tabelle in Figur 2 ausgewählt (8.7). Es erfolgt dann eine Steuerung über eine gewisse Steuerzeit, die optimal auf den ersten erkannten Fehlertyp ausgerichtet ist (8.8), beispielsweise für eine Zeitdauer von rund 1 Millisekunde. Im Anschluß daran (8.9) wird die Steuerstrategie abgeändert (Auswahl nach Tabelle der Figur 2), um dann für einen weiteren Zeitraum von etwa 1 Millisekunde optimal auf den zweiten erkannten Fehler ausgerichtet zu sein. Sofern bei der Überprüfung kein aktueller Zündkreisdoppelfehler erkannt wird, erfolgt gemäß Schritt 8.10 die Auswahl einer optimalen Ansteuerungsstrategie entsprechend dem aktuellen Zündkreisstatus aus der Tabelle gemäß Figur 2. Im Anschluß (8.11) erfolgt dann die Ansteuerung der Zündpillen nach der optimierten Steuerungsstrategie. Im Schritt 8.12 wird in Meßintervallen von rund 100 Mikrosekunden wiederum jeweils der aktuelle Zündkreisstatus überprüft (z.B. Kurzschlußerkennung) und die zur Verfügung stehende Versorgungsspannung gemessen. Im Schritt 8.13 wird wiederum abgefragt, ob es aktuelle Zündkreisdoppelfehler gibt. Alternativ kann dann wiederum die Schleife 8.14, 8.15, 8.16, 8.17, 8.18 oder die Schleife 8.13, 8.19, 8.20 abgearbeitet werden. Im Schritt 8.21 wird zusätzlich festgestellt, ob es gegebenenfalls abgespeicherte Fehlerzustände gibt. Sollte das nicht der Fall sein (8.22), wird überprüft (8.23) ob die Gesamtauslösedauer kleiner ist als eine bestimmte Grenzdauer TG (TG ungefähr 8 Millisekunden). Sollte das der Fall sein (8.24), wird an den Verzweigungspunkt C bei 8.4 zurückgekehrt. Sollte das nicht der Fall sein (8.25) wird in 8.26 das Ende des Auslösevorgangs erreicht. Sofern es gespeicherte Fehler gibt (8.27) wird bei 8.28 wiederum abgefragt, ob es Zündkreisdoppelfehler gibt. Alternativ erfolgt dann eine Verzweigung zu 8.29, 8.30, 8.31, 8.32 um letztlich bei 8.33 in den Hauptzweig zurückzukehren, der bei 8.40 das Ende der Auslösung erreicht. Falls keine Zündkreisdoppelfehler erkannt werden (8.34) wird (8.35) aus der Tabelle gemäß Figur 2 wiederum der optimale Ansteuerungsmodus ausgewählt. Die entsprechende Auslösung erfolgt dann bei 8.36.

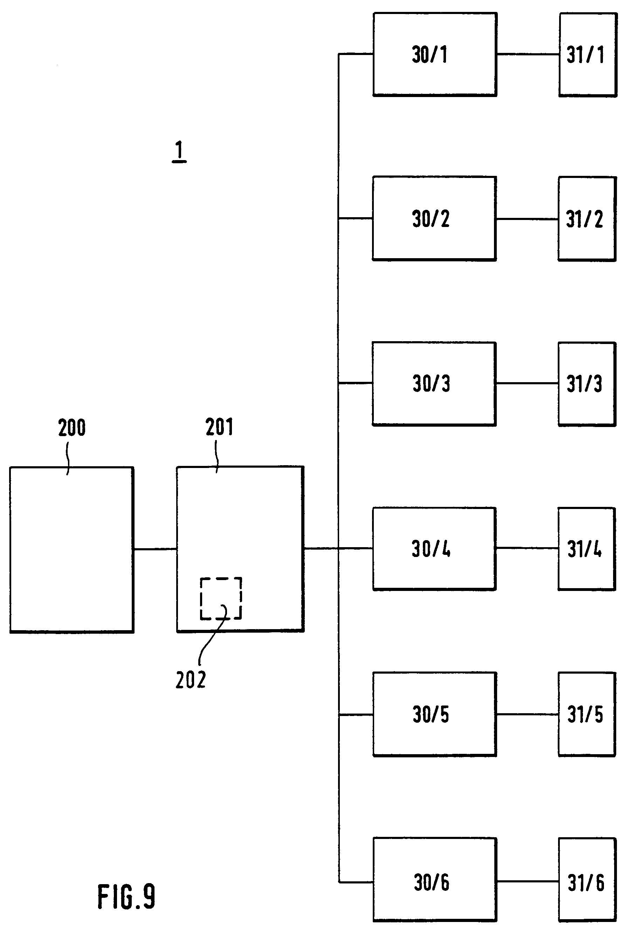

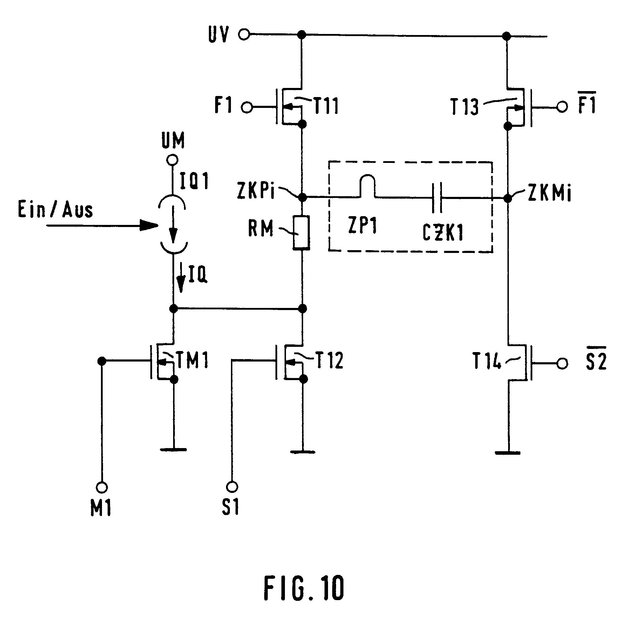

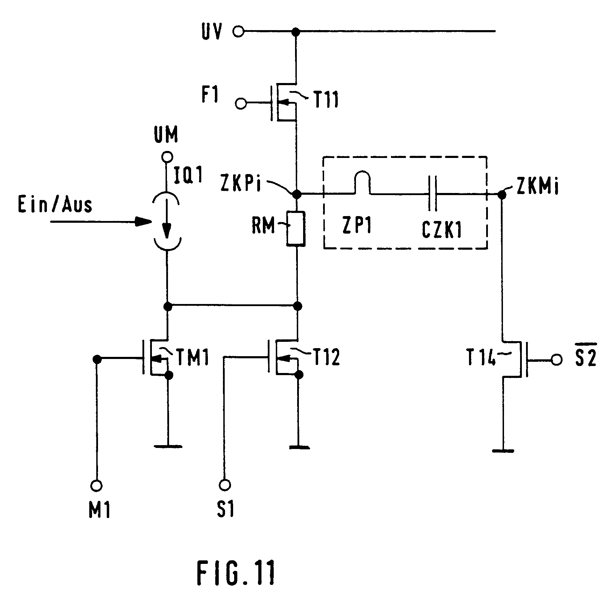

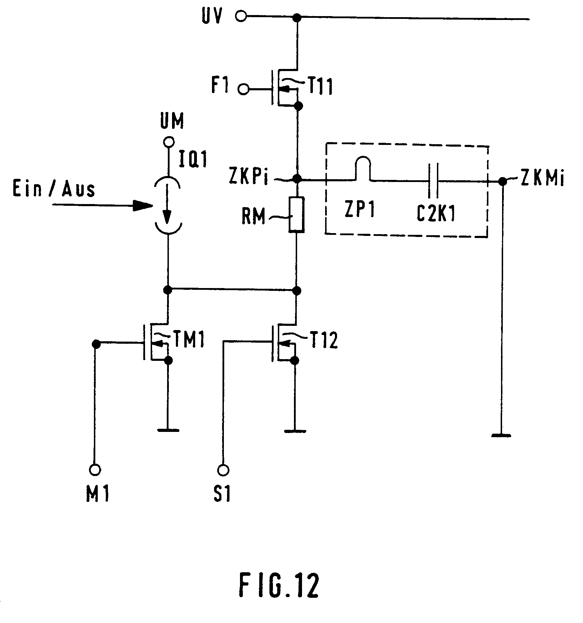

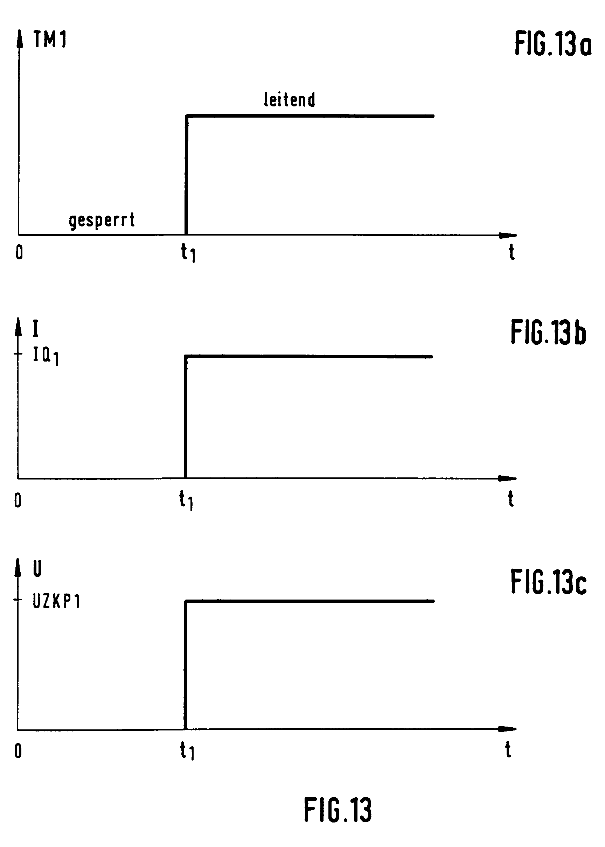

Figur 9 zeigt als Blockschaltbild ein weiteres Ausführungsbeispiel einer Sicherheitseinrichtung 1 mit einem Sensor 200, einem Steuergerät 201 mit Speichermitteln 202 und einer Vielzahl von Rückhaltemitteln 31/1, 31/2, ... 31/6 und diesen zugeordneten Endstufen 30/1, 30/2, ...30/6. Derartig viele Endstufen und Rückhaltemittel werden bei modernen Fahrzeugen eingeplant, die beispielsweise mit folgenden Sicherungseinrichtungen ausgestattet sind: Gurtstraffer für Fahrer, Gurtstraffer für Beifahrer, Airbag für Fahrer, Airbag für Beifahrer, Seitenairbag für Fahrer und Seitenairbag für Beifahrer. Auch ist heute schon ein Trend erkennbar, daß über die in Figur 9 beispielhaft dargestellte Anzahl von sechs Rückhaltemitteln bzw. sechs zugeordneten Endstufen in Zukunft noch eine größere Anzahl von Rückhaltemitteln und Endstufen zum Einsatz gelangt, wenn beispielsweise auch Fondpassagiere von Fahrzeugen mit derartigen Sicherheitseinrichtungen ausgestattet werden sollen. Die Endstufen 30/1, ...30/6 sind, wie ein beispielhaft dargestellte Ausführungsbeispiel gemäß Figur 10 zeigt, selbst relativ komplex gestaltet. In Serie und parallel geschaltet sind eine Vielzahl von Schaltelementen T11, T12, T13, T14. Für den Fachmann ersichtlich, stellt das Ausführungsbeispiel nach Figur 10 eine Brückenschaltung dar, die auch als Vollbrücke bezeichnet wird. Darüber hinaus sind vereinfachte Varianten, wie beispielsweise in Form einer sogenannten 3/4-Brücke oder einer 1/2-Brücke denkbar, die in Figur 11 bzw. 12 beispielhaft dargestellt sind. Aus Rationalisierungsgründen und Zuverlässigkeitsgründen bietet es sich nun an, die zuvor besprochenen Endstufen, zumindest wesentliche Teile davon, auch in integrierter Form herzustellen. So ist es beispielsweise zweckmäßig, zumindest die zuvor erwähnten Schaltelemente als Halbleiterschalter auszubilden und diese in integrierter Technik herzustellen. Dies ist mit heute vorhandenen technischen Mitteln ohne weiteres möglich, sofern die Schaltelemente als Leistungs-MOSFET-Transistoren ausgestaltet werden. Bei heute beherrschbaren Prozessen für integrierte Schaltungen lassen sich jedoch nur Halbleiterschaltelemente herstellen, deren Übergangswiderstand im eingeschalteten Zustand in der Größenordnung von 0,5 bis etwa 1,5 Ohm liegt. Der Ein-Widerstand dieser Schaltelemente liegt damit aber in der Größenordnung des Widerstandes von herkömmlichen Zündpillen, die ebenfalls Widerstandswerte in der Größenordnung von einigen Ohm aufweisen, zum Beispiel also zwischen 1 und 3 Ohm liegen. Bei derartigen Widerstandsverhältnissen können die mit diskreten Leistungs-MOSFETS üblichen Verfahren zur Überprüfung der Zündkreise jedoch nicht mehr erfolgreich angewandt werden. Die erwähnten Widerstandswerte der Halbleiterschaltelemente sind nämlich zudem noch stark temperaturabhängig. Wählt man beispielsweise in dem Ausführungsbeispiel nach Figur 10 den Entladewiderstand RM etwa zu etwa 10 Ohm, dann lassen sich Änderungen des Widerstandes der Zündpillen in der Größenordnung weniger 100 Milliohm, die für die Beurteilung der Funktionsweise der Endstufe außerordentlich bedeutend sind, kaum noch von temperaturbedingten Änderungen unterscheiden. Eine Lösung dieses Problems wird erfindungsgemäß dadurch erreicht, daß neben ersten Schaltelementen T11, T12, T13, T14, die gemäß Ausführungsbeispiel nach Figur 10 eine Brückenschaltung bilden und die Zündpille ZP1 und den Kondensator CZK1 einschließen, zusätzlich noch zweite Schaltelemente, im Ausführungsbeispiel nach Figur 10 das Schaltelement TM1 vorgesehen werden, die einen wesentlich höheren Wert des Durchgangswiderstandes im eingeschalteten Zustand aufweisen. Zweckmäßigerweise beträgt der Übergangswiderstand des zweiten Schaltelements TM1 in dem eingeschalteten Zustand das Zehn- bis etwa Hundertfache des Übergangswiderstandes der ersten Schaltelemente T11, T12, ...T14. Dies läßt sich bei Herstellung der Halbleiterschaltelemente in integrierter Technik dadurch erreichen, daß für das zweite Schaltelement TM1 eine wesentlich kleinere Chipfläche vorgesehen wird. Beispielsweise wird die Chipfläche der zweiten Schaltelemente etwa um den Faktor 10 bis 100 mal kleiner gewählt als die Chipfläche der ersten Schaltelemente, so daß sich bei den zweiten Schaltelementen der wesentlich größere Übergangswiderstand im eingeschalteten Zustand ergibt. In dem Blockschaltbild der Figur 10 ist weiter eine mit IQ1 bezeichnete Stromquelle dargestellt, die in Serie zu dem Schaltelement TM1 geschaltet ist. Werden die ersten und die zweiten Schaltelemente, wie erwähnt, vorzugsweise in integrierter Technik hergestellt, sollte auch diese Stromquelle IQ1 am besten in integrierter Technik erzeugt werden. In der einfachsten Form kann eine derartige Stromquelle beispielsweise als Spannungsteiler realisiert werden, der zwischen dem positiven Pol der Versorgungsspannung und dem Masseanschluß angeschlossen ist. Diese Stromquelle IQ1 kann beispielsweise einen Strom IQ abgeben, der in der Größenordnung zwischen etwa 10 und etwa 100 Milliampere liegt. Eine Überprüfung der in Figur 10 dargestellten Endstufe unter Zuhilfenahme des zweiten Schaltelements TM1 wird unter Bezugnahme auf das in Figur 13 dargestellte Funktionsdiagramm im folgenden näher erläutert. Dabei zeigt Figur 13a den jeweiligen Leitungszustand des Schaltelements TM1, Figur 13b den Betriebszustand der Stromquelle IQ1 und Figur 13c eine Kurve, die den Spannungsverlauf als Funktion der Zeit an dem Übergangswiderstand des Schaltelements TM1 angibt. Aus Figur 13a geht hervor, daß das Schaltelement TM1 in dem Zeitintervall 0,t1 gesperrt ist und anschließend in einen leitenden Zustand gesteuert ist. Auch die Stromquelle IQ1 ist im Zeitintervall 0,t1 ausgeschaltet und speist ab dem Zeitpunkt t1 den Strom IQ1 ein. Die Einschaltung der Stromquelle IQ1 und die Steuerung des Schaltelements TM1 wird zweckmäßig von dem Steuergerät 201 (vergleiche Figur 9) bewirkt Das Schaltelement TM1 ist dazu über seinen Steueranschluß M1 mit dem Steuergerät 201 verbunden. In Figur 13c ist der Spannungsabfall UZKP1 dargestellt, der sich an dem Übergangswiderstand des Schaltelements TM1 in seinem eingeschalteten Zustand infolge des von der Stromquelle IQ gelieferten Stroms IQ1 ergibt. Dieser Spannungsabfall ergibt sich als Produkt des letztgenannten Stroms mit dem Wert des Übergangswiderstands. Dieser Spannungsabfall UZKP1 wird zweckmäßig ebenfalls von dem Steuergerät 201 erfaßt und für weitere Berechnungen zur Verfügung gestellt. Dabei wird, auf an sich bekannte Weise der als analoger Spannungswert vorliegende Spannungsabfall vermittels eines A/D-Wandlers in einen entsprechenden Digitalwert umgewandelt, der zur Weiterverarbeitung zur Verfügung steht. Aus dem gemessenen Spannungsabfall UZKP1 und dem bekannten Strom IQ1 der Stromquelle IQ kann das Steuergerät 201 unter Berücksichtigung des ohmschen Gesetzes den zum Meßzeitpunkt vorliegenden Übergangswiderstand des Schaltelements TM1 bestimmen. Wenn nun aber durch die Messung des Spannungsabfalls UZKP1 und des Stroms IQ1 der Stromquelle IQ und anschließende Berechnung nach dem ohmschen Gesetz der Wert des Übergangswiderstandes des Schaltelements TM1 ermittelt worden ist, steht mit großer Genauigkeit auch der Wert der jeweiligen Übergangswiderstände der Schaltelemente T11, T12, T13, T14 fest, da diese aufgrund der Flächenverhältnisse der Chipflächen proportional zu dem Übergangswiderstand des Schaltelements TM1 sind. Wenn aber nun die Übergangswiderstände der Schaltelemente T11, T12, T13, T14 hinreichend gut bekannt sind, kann auf einfache Weise auch vermittels eines über die Zündpille ZP1 geleiteten Prüfstroms der Wert des Zündpillenwiderstandes jederzeit mit großer Genauigkeit ermittelt und somit auf die Funktionsfähigkeit der Zündpille ZP1 geschlossen werden. Unter Berücksichtigung unvermeidbarer Toleranzen bezüglich des Prüfstroms und des Maßstabfaktors bei der Berücksichtigung der Verhältnisse der Chipflächen zwischen den ersten und den zweiten Schaltelementen lassen sich Toleranzbereiche bei der Ermittlung des aktuellen Widerstandswertes der Zündpille ZP1 ableiten, die in der Größenordnung einiger 10 Milliohm liegen. Diese vergleichsweise geringen Abweichungen lassen erwarten, daß der Wert des Widerstands der Zündpille ZP1 mit hinreichend großer Genauigkeit ermittelt werden kann, so daß auftretende Fehler rechtzeitig und zuverlässig feststellbar sind. Vergleichbare Vorteile ergeben sich in den in Figur 11 und 12 dargestellten vereinfachten Ausführungsbeispielen der Endstufen. Figur 10, Figur 11 und Figur 12 stellen jeweils nur eine Endstufe mit jeweils einer Zündpille ZP1 dar. Es versteht sich von selbst, daß, wie in Figur 9 dargestellt, selbstverständlich mehrere derartiger Endstufen vorgesehen sein können, denen jeweils nur ein einziges zweites Schaltelement TM1 und eine zugeordnete Stromquelle IQ zugeordnet sein könnte. Im Falle der Integration aller Endstufen 30/1, ... 30/6 auf einem einzigen Schaltelement könnte selbstverständlich auch daran gedacht werden, für alle Endstufen gemeinsam ein derartiges zweites Schaltelement TM1 und einzige Stromquelle IQ vorzusehen.

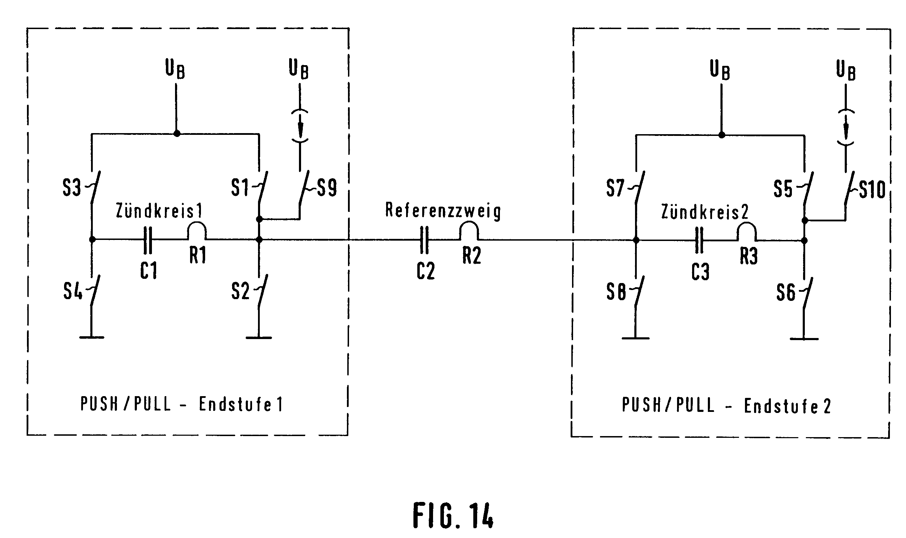

Auch bei den nachfolgend beschriebenen Ausführungsbeispielen ist eine Erfassung und Berücksichtigung des Übergangswiderstands von insbesondere in integrierter Technik hergestellten Schaltelementen möglich. Dabei ist ein zusätzlicher Referenzzweig vorgesehen, während im Gegensatz zu den zuvor beschriebenen Ausführungsbeispielen auf eine besondere Stromquelle verzichtet werden kann. In dem Ausführungsbeispiel nach Figur 14 sind zwei in Brückenschaltung ausgeführte Push/Pull-Endstufen zur Ansteuerung je eines Zündkreises C1, R1 bzw. C3, R3 vorgesehen. C1 und C3 sind wiederum Kondensatoren, die in Reihe zu einer ihr durch die Widerstände R1, R3 repräsentierten Zündpille geschaltet sind. Bei den Schaltelementen S1, S2, S3, S4, S9 der ersten Endstufe und S5, S6, S7, S8, S10 der zweiten Endstufe handelt es sich vorzugsweise um in integrierter Technik hergestellte Schaltelemente, insbesondere um MOS-Transistoren. Zwischen die Endstufen ist ein aus der Serienschaltung eines Kondensators C2 und des Widerstandes R2 bestehender Referenzzweig geschaltet. Mit UB ist die Betriebsspannung bezeichnet. Eine Widerstandsmessung kann wie folgt durchgeführt werden. Zunächst wird das Schaltelement S4 geschlossen, durch Schließen des Schaltelements S9 wird die Serienschaltung des Zündkreises C1, R1 an die Betriebsspannung UB gelegt und der Kondensator C1 aufgeladen. Aus der Aufladekurve läßt sich der Kapazitätswert des Kondensators C1 bestimmen. Durch kurzzeitiges Schließen der Schaltelemente S2 und S4 für eine bestimmte Zeit t wird der Kondensator C1 über den Widerstand R1 des Zündkreises entladen. Die an dem Kondensator C1 dann noch anstehende Spannung ist ein Maß für den Wert des Widerstands R1, wobei in Abhängigkeit von dem zuvor beschriebenen Meßvorgang eine Korrektur vorgenommen werden muß. In die beschriebene Widerstandsmessung gehen als störgrößen die Übergangswiderstände der Schaltelemente S2 und S4 mit ein. Diese Übergangswiderstände unterliegen der Exemplarstreuung und sind in der Regel auch stark temperaturabhängig. Bei dem zuvor beschriebenen zweiten Meßschritt wird demnach nicht der Widerstandswert des Widerstandes R1, sondern ein Widerstandswert gemessen, der eine Summe des Widerstandswertes des Widerstandes R1 und des zweifachen Übergangswiderstandes (Schaltelement S2, S4) ist. Damit nun der Übergangswiderstand zum Zwecke der Korrektur bestimmt werden kann, wird eine Vergleichsmessung in einem aus dem Kondensator C2 und dem Widerstand R2 bestehenden Referenzzweig durchgeführt. Der aus C2 und R2 bestehende Referenzzweig liegt zwischen zwei Push/Pull-Endstufen, die je einen Zündkreis C1, R1 bzw. C3, R3 ansteuern. Diese Push/Pull-Endstufen können, wie in Figur 14 dargestellt, als Vollbrücken oder, durch Weglassen der Schaltelemente S3, S7, auch als 3/4-Brücken ausgeführt sein. Eine derartige Anordnung des Referenzzweiges C2, R2 ermöglicht die Messung des Referenzwiderstandes dieses Referenzzweiges ohne zusätzliche weitere Bauelemente. Die Messung des Widerstandes im Referenzzweig erfolgt im wesentlichen auf dieselbe Art und Weise wie die zuvor beschriebenen Messungen. So wird zunächst durch Schließen der Schaltelemente S8, S9 der Kondensator C2 des Referenzzweiges aufgeladen. Andererseits wird durch Schließen der Schaltelemente S2, S8 der Kondensator C2 zumindest teilweise entladen. Wie oben schon erwähnt, kann aus diesem Entladevorgang ein Widerstandswert im Referenzzweig bestimmt werden. Das Meßergebnis stellt jedoch die Summe aus dem Wert des Referenzwiderstandes R2 und den Übergangswiderständen der Schaltelemente S2 und S8 dar. Da der Widerstand des Referenzwiderstandes R2 im Referenzzweig jedoch bekannt ist, läßt sich jetzt der Übergangswiderstand der Schaltelemente S2, S8 im geschlossenen Zustand berechnen. Mit Hilfe dieses nunmehr bekannten Übergangswiderstandes ist eine Korrektur des in zuvor beschriebenen Meßvorgängen ermittelten Widerstandswertes des Widerstandes R1 (bzw. R3) in den Zündkreisen möglich.

Bei einer Integration der Schaltelemente S1, ....S8 in integrierter Technik ist die Streuung zwischen den Übergangswiderständen dieser Schaltelemente sehr gering, da zum einen die Streuung der Parameter auf denselben integrierten Schaltkreis gering ist und zum anderen alle Schaltelemente im wesentlichen dieselbe Betriebstemperatur aufweisen. Durch die beschriebene Referenzmessung ist demnach eine fast vollständige Korrektur des Einflusses der Übergangswiderstände der Schaltelemente auf den Widerstandswert der Zündkreise möglich. Wird ein Endstufenschaltkreis nicht nur mit zwei Endstufen, wie in Figur 14 dargestellt, betrieben, sondern mit noch mehreren, beispielsweise vier vollständigen Brückenschaltungen, dann ist dennoch lediglich ein einzelner Referenzzweig für jeden integrierten Schaltkreis notwendig, um die erforderliche Korrektur durchzuführen.

Damit bei der gleichzeitigen Ansteuerung der Zündkreise C1, R1 bzw. C3, R3 keine Energie im Referenzzweig C2,R2 verloren geht, wird das Schaltelement S1 gleichzeitig mit dem Schaltelement S7 und das Schaltelement S2 gleichzeitig mit dem Schaltelement S8 getaktet. Soll nur ein Zündkreis angesteuert werden, also beispielsweise nur der Zündkreis C1, R1, dann werden die Schaltelemente des zweiten Zündkreises C3, R3 nicht geschlossen.

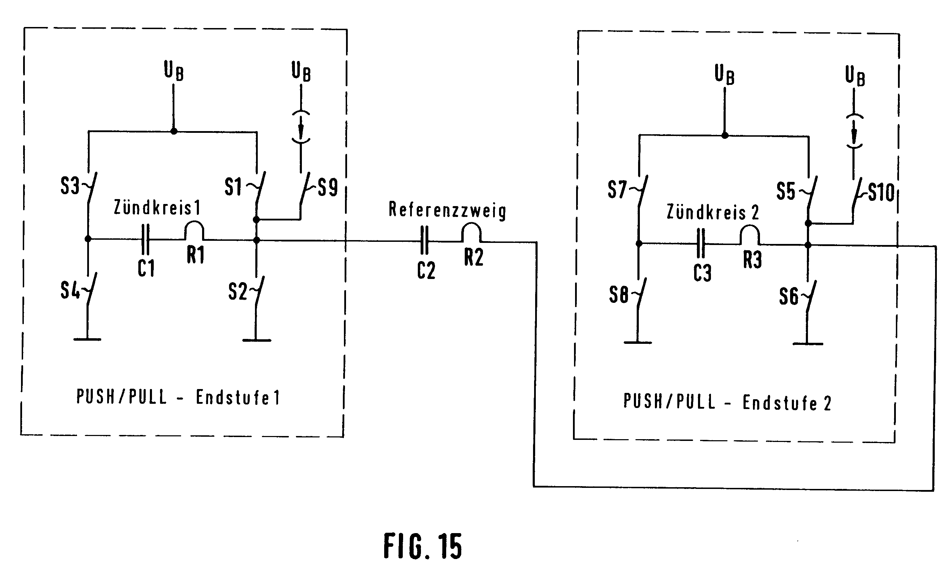

Figur 15 zeigt eine Variante der in Figur 14 dargestellten Schaltungsanordnung. Bei dieser ist der dem Kondensator C2 des Referenzzweiges abgewandte Anschluß des Widerstandes R2 des Referenzzweiges jetzt mit dem dem Kondensator C3 des zweiten Zündkreises abgewandten Anschluß des Widerstandes R3 verbunden. Für diese Anordnung gelten die schon im Zusammenhang mit Figur 14 beschriebenen Meßschritte entsprechend. Statt des Schaltelementes S8 wird jedoch bei der Zündkreismessung das Schaltelement S6 angesteuert und bei der Zündung wird das Schaltelement S1 gleichzeitig mit dem Schaltelement S5 und dem Schaltelement S2 gleichzeitig mit dem Schaltelement S6 angesteuert.

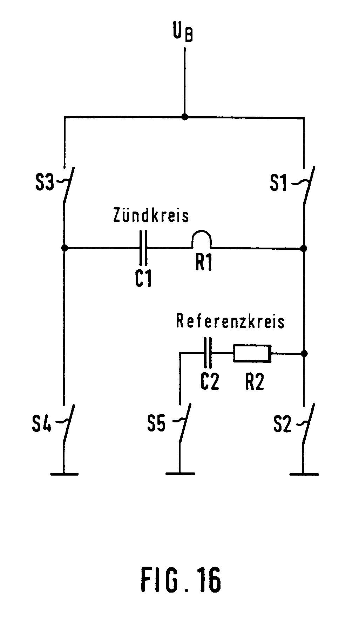

Eine weitere Ausführungsform der Schaltungsanordnung ist in Figur 16 dargestellt, wobei die Darstellung auf lediglich eine Vollbrückenschaltung beschränkt ist. Eine dieser Vollbrückenschaltungen der in integrierter Technik ausgeführten Endstufe erhält zusätzlich ein weiteres Schaltelement S5, bei dem es sich ebenfalls vorzugsweise um einen in MOS-Technik ausgeführten Endstufentransistor handelt, der im wesentlichen baugleich ist mit den Schaltelementen S2 bzw. S4. Der für Meßzwecke vorgesehene Referenzkreis mit dem Kondensator C2 und dem Widerstand R2 ist jetzt zwischen je einem Pol des Schaltelements S5 und des Schaltelements S2 eingeschlossen. Für den Fall, daß die in Figur 16 dargestellte Endstufe lediglich als 3/4-Brücke ausgeführt werden soll, kann das Schaltelement S3 entfallen.

## Patentansprüche

1. Elektronische Sicherheitseinrichtung (1) für Fahrzeuginsassen mit einem beschleunigungsempfindlichen Sensor (200), mit einem, mindestens einen Mikrorechner (20) umfassenden Steuergerät, mit mindestens einem Rückhaltemittel (22,23,31) und einer dieses Rückhaltemittel steuernden Endstufe (30), die mindestens eine Zündpille (ZPF,ZPBF) umfaßt, wobei
die Sicherheitseinrichtung (1) Speichermittel (202) umfaßt, in denen Fehlerzustände der Sicherheitseinrichtung und diesen Fehlerzuständen zugeordnete Steueranweisungen abgespeichert sind, die eine erfolgreiche Aktivierung des mindestens einen Rückhaltemittels (22,23,31) auch bei Auftreten von Fehlerzuständen ermöglichen;
dadurch gekennzeichnet, daß die Endstufe mindestens ein Schaltelement (T2) umfaßt, die Steueranweisungen von der Versorgungsspannung abhängig sind; und
daß bei einer zwischen etwa 30 Volt und etwa 45 Volt liegenden Versorgungsspannung und einem Kurzschluß zwischen dem massefernen Anschluß (FP, BFP) der Zündpille (ZPF,ZPBF) und dem positiven Pol der Versorgungsspannung mindestens das Schaltelement (T2) taktweise (Zeittakt T) derart ansteuerbar ist, daß es in einem ersten Zeitintervall (TI) leitend gesteuert, und in einem zweiten Zeitintervall (TII) gesperrt ist.

2. Elektronische Sicherheitseinrichtung nach 1, dadurch gekennzeichnet, daß in der Sperrphase (TII) des Schaltelements (T2) die Schaltelemente (T5,T6) leitend gesteuert sind.

3. Elektronische Sicherheitseinrichtung nach einem der Ansprüche 1, 2, dadurch gekennzeichnet, daß die Zeitintervalle (TI,TII) gleich lang bemessen sind.

4. Elektronische Sicherheitseinrichtung nach einem der Ansprüche 1 bis 3, dadurch gekennzeichnet, daß die Dauer des Zeitintervalls (TI) zwischen 5 und 10 Mikrosekunden, vorzugsweise 7 Mikrosekunden beträgt.

5. Elektronische Sicherheitseinrichtung nach einem der Ansprüche 1 bis 4, dadurch gekennzeichnet, daß während dem Zeitintervalle (TI,TII) zusätzlich auch die Schaltelemente (T3,T4) leitend bzw. gesperrt gesteuert sind.

6. Elektronische Sicherheitseinrichtung (1) für Fahrzeuginsassen mit einem beschleunigungsempfindlichen Sensor (200), mit einem, mindestens einen Mikrorechner (20) umfassenden Steuergerät, mit mindestens einem Rückhaltemittel (22,23,31) und einer diese Rückhaltemittel steuernden Endstufe (30), die mindestens eine Zündpille (ZPF,ZPBF) umfaßt, wobei
die Sicherheitseinrichtung (1) Speichermittel (202) umfaßt, in denen Fehlerzustände der Sicherheitseinrichtung und diesen Fehlerzuständen zugeordnete Steueranweisungen abgespeichert sind, die eine erfolgreiche Aktivierung des mindestens einen Rückhaltemittels (22,23,31) auch bei Auftreten von Fehlerzuständen ermöglichen;
dadurch gekennzeichnet, daß die Endstufe (30) mehrere Schaltelement umfaßt, die Steueranweisungen von der Versorgungsspannung abhängig sind; und
daß bei einer zwischen etwa 24 Volt und etwa 30 Volt liegenden Versorgungsspannung und einem Kurzschluß zwischen dem massefernen Anschluß (FP, BFP) der Zündpille (ZPF,ZPBF) und dem positiven Pol der Versorgungsspannung oder einem Kurzschluß zwischen dem massefernen Anschluß (FP, BFP) der Zündpille (ZPF,ZPBF) und dem Masseanschluß mindestens das Schaltelement (T2) taktweise (Zeittakt T) derart ansteuerbar ist, daß es in einem ersten Zeitintervall (TI) leitend gesteuert, und in einem zweiten Zeitintervall (TII) gesperrt ist, und daß in der Sperrphase (TII) des Schaltelementes (T2) die Schaltelemente (T5,T6) leitend gesteuert sind.

7. Elektronische Sicherheitseinrichtung nach Anspruch 6, dadurch gekennzeichnet, daß die Dauer der Zeitintervalle (TI,TII) zwischen 3 und 10 Mikrosekunden, vorzugsweise 5 Mikrosekunden, beträgt.

8. Elektronische Sicherheitseinrichtung (1) für Fahrzeuginsassen mit einem beschleunigungsempfindlichen Sensor (200), mit einem mindestens einen Mikrorechner (20) umfassenden Steuergerät, mit mindestens einem Rückhaltemittel (22,23,31) und einer dieses Rückhaltmittel steuernden Endstufe (30), die mindestens eine Zündpille (ZPF,ZPBF) umfaßt, wobei
die Sicherheitseinrichtung (1) Speichermittel (202) umfaßt, in denen Fehlerzustände der Sicherheitseinrichtung und diesen Fehlerzuständen zugeordnete Steueranweisungen abgespeichert sind, die eine erfolgreiche Aktivierung des mindestens einen Rückhaltemittels (22,23,31) auch bei Auftreten von Fehlerzuständen ermöglichen;
dadurch gekennzeichnet, daß die Endstufe (30) mehrere Schaltelemente umfaßt, die Steueranweisungen von der Versorgungsspannung abhängig sind; und
daß bei einer zwischen etwa 9 Volt und etwa 24 Volt liegenden Versorgungsspannung und einem Kurzschluß zwischen dem massefernen Anschluß (FP, BFP) der Zündpille (ZPF,ZPBF) und dem positiven Pol der Versorgungsspannung die Schaltelemente (T1,T2), beziehungsweise (T3,T4,T5,T6) im Gegentaktbetrieb taktweise (Zeittakt T,TI,TII) derart ansteuerbar sind, daß in einem ersten Zeitintervall (TI) die Schaltelemente (T2,T3,T4) leitend, die Schaltelemente (T1,T5,T6) gesperrt gesteuert, und in einem zweiten Zeitintervall (TII) die Schaltelemente (T1,T5,T6) leitend und die Schaltelemente (T2,T3,T4) gesperrt gesteuert sind.

9. Elektronische Sicherheitseinrichtung nach Anspruch 8, dadurch gekennzeichnet, daß die Dauer des Zeitintervalls (TI,TII) zwischen 2 und 8 Mikrosekunden, vorzugsweise 3 Mikrosekunden, beträgt.

10. Elektronische Sicherheitseinrichtung (1) für Fahrzeuginsassen mit einem beschleunigungsempfindlichen Sensor (200), mit einem, mindestens einen Mikrorechner (20) umfassenden Steuergerät, mit mindestens einem Rückhaltemittel (22,23,31) und einer dieses Rückhaltemittel steuernden Endstufe (30), die mindestens eine Zündpille (ZPF,ZPBF) umfaßt, wobei
die Sicherheitseinrichtung (1) Speichermittel (202) umfaßt, in denen Fehlerzustände der Sicherheitseinrichtung und diesen Fehlerzuständen zugeordnete Steueranweisungen abgespeichert sind, die eine erfolgreiche Aktivierung des mindestens einen Rückhaltemittels (22,23,31) auch bei Auftreten von Fehlerzuständen ermöglichen;
dadurch gekennzeichnet, daß die Endstufe mehrere Schaltelemente umfaßt, die Steueranweisungen von der Versorgungsspannung abhängig sind; und
daß bei einer zwischen etwa 30 Volt und etwa 45 Volt liegenden Versorgungsspannung und einem Kurzschluß zwischen dem massenahen Anschluß (FM, BFM) eines mit der Zündpille (ZPF,ZPBF) in Serie geschalteten Kondensators (CF,CBF) und dem positiven Pol der Versorgungsspannung oder dem Masseanschluß mindestens das Schaltelement (T1) taktweise (Zeittakt T) derart ansteuernar ist, daß es in einem ersten Zeitintervall (TI) leitend gesteuert, und in einem zweiten Zeitintervall (TII) gesperrt ist, während die Schaltelemente (T3,T4) während des ersten Zeitintervalls (TI) gesperrt und während des zweiten Zeitintervalls (TII) leitend gesteuert sind.

11. Elektronische Sicherheitseinrichtung nach einem der Ansprüche 1 bis 10, dadurch gekennzeichnet, daß die Schaltelemente Halbleiterbauelemente sind.

12. Elektronische Sicherheitseinrichtung nach einem der Ansprüche 1 bis 11, dadurch gekennzeichnet, daß die Endstufe (30, 30/1,...30/6) erste Schaltelemente (T1,T2,...T6, T11,T12,...T14) und zweite Schaltelemente (TM1,...,TM6) umfaßt, die in integrierter Technik hergestellt sind.

13. Elektronische Sicherheitseinrichtung nach Anspruch 12, dadurch gekennzeichnet, daß die ersten und zweiten Schaltelemente mindestens zwei definierte Schaltzustände einnehmen können, nämlich einen EIN-Zustand und einen AUS-Zustand, und daß in dem EIN-Zustand der Übergangswiderstand der zweiten Schaltelemente TM1,...,TM6) wesentlich größer ist als der Übergangswiderstand der ersten Schaltelemente (T1,T2,...T6, T11,T12,...T14).

14. Elektronische Sicherheitseinrichtung nach einem der Ansprüche 12,13 dadurch gekennzeichnet, daß in dem EIN-Zustand der Übergangswiderstand der zweiten Schaltelemente um einen Faktor 10 bis 100 größer ist als der Übergangswiderstand der ersten Schaltelemente.

15. Elektronische Sicherheitseinrichtung nach einem der Ansprüche 1 bis 14, dadurch gekennzeichnet, daß für die Bestimmung des Übergangswiderstandes der Schaltelemente ein aus einer Serienschaltung eines Kondensators (C2) und eines Widerstands (R2) bestehender Referenzzweig vorgesehen ist, dessen Kondensator (C2) durch entsprechende Schaltlage der Schaltelemente auf- bzw. entladbar ist.

## Claims

1. Electronic safety device (1) for vehicle occupants having an acceleration-sensitive sensor (200), having a control unit comprising at least one microcomputer (20), having at least one restraining means (22, 23, 31) and an output stage (30), which controls this restraining means and comprises at least one firing pellet (ZPF, ZPBF), the safety device (1) comprising storage means (202), in which are stored fault states of the safety device and control instructions which are assigned to these fault states and enable successful activation of the at least one restraining means (22, 23, 31) even when fault states occur, characterized in that the output stage comprises at least one switching element (T2), the control instructions are dependent on the supply voltage, and in that in the event of a supply voltage of between about 30 volts and about 45 volts and a short circuit between that terminal (FP, BFP) of the firing pellet (ZPF, ZPBF) which is remote from earth and the positive pole of the supply voltage, at least the switching element (T2) can be driven cyclically (timing pulse T) in such a way that it is turned on in a first time interval (TI) and is turned off in a second time interval (TII).

2. Electronic safety device according to Claim 1, characterized in that the switching elements (T5, T6) are turned on in the turned-off phase (TII) of the switching element (T2).

3. Electronic safety device according to one of Claims 1, 2, characterized in that the time intervals (TI, TII) are dimensioned to be of equal length.

4. Electronic safety device according to one of Claims 1 to 3, characterized in that the duration of the time interval (TI) is between 5 and 10 microseconds, preferably 7 microseconds.

5. Electronic safety device according to one of Claims 1 to 4, characterized in that, in addition, the switching elements (T3, T4) are also turned on and off, respectively, during the time intervals (TI, TII).

6. Electronic safety device (1) for vehicle occupants having an acceleration-sensitive sensor (200), having a control unit comprising at least one microcomputer (20), having at least one restraining means (22, 23, 31) and an output stage (30), which controls this restraining means and comprises at least one firing pellet (ZPF, ZPBF), the safety device (1) comprising storage means (202), in which are stored fault states of the safety device and control instructions which are assigned to these fault states and enable successful activation of the at least one restraining means (22, 23, 31) even when fault states occur, characterized in that the output stage (30) comprises a plurality of switching elements, the control instructions are dependent on the supply voltage, and in that, in the event of a supply voltage of between about 24 volts and about 30 volts and a short circuit between that terminal (FP, BFP) of the firing pellet (ZPF, ZPBF) which is remote from earth and the positive pole of the supply voltage or a short circuit between that terminal (FP, BFP) of the firing pellet (ZPF, ZPBF) which is remote from earth and the earth terminal, at least the switching element (T2) can be driven cyclically (timing pulse T) in such a way that it is turned on in a first time interval (TI) and is turned off in a second time interval (TII), and in that the switching elements (T5, T6) are turned on in the turned-off phase (TII) of the switching element (T2).

7. Electronic safety device according to Claim 6, characterized in that the duration of the time intervals (TI, TII) is between 3 and 10 microseconds, preferably 5 microseconds.

8. Electronic safety device (1) for vehicle occupants having an acceleration-sensitive sensor (200), having a control unit comprising at least one microcomputer (20), having at least one restraining means (22, 23, 31) and an output stage (30), which controls this restraining means and comprises at least one firing pellet (ZPF, ZPBF), the safety device (1) comprising storage means (202), in which are stored fault states of the safety device and control instructions which are assigned to these fault states and enable successful activation of the at least one restraining means (22, 23, 31) even when fault states occur, characterized in that the output stage (30) comprises a plurality of switching elements, the control instructions are dependent on the supply voltage, and in that, in the event of a supply voltage of between about 9 volts and about 24 volts and a short circuit between that terminal (FP, BFP) of the firing pellet (ZPF, ZPBF) which is remote from earth and the positive pole of the supply voltage, the switching elements (T1, T2) and (T3, T4, T5, T6), respectively, can be driven cyclically (timing pulse T, TI, TII) in push-pull operation in such a way that the switching elements (T2, T3, T4) are turned on and the switching elements (T1, T5, T6) are turned off in a first time interval (TI), and the switching elements (T1, T5, T6) are turned on and the switching elements (T2, T3, T4) are turned off in a second time interval (TII).

9. Electronic safety device according to Claim 8, characterized in that the duration of the time interval (TI, TII) is between 2 and 8 microseconds, preferably 3 microseconds.

10. Electronic safety device (1) for vehicle occupants having an acceleration-sensitive sensor (200), having a control unit comprising at least one microcomputer (20), having at least one restraining means (22, 23, 31) and an output stage (30), which controls this restraining means and comprises at least one firing pellet (ZPF, ZPBF), the safety device (1) comprising storage means (202), in which are stored fault states of the safety device and control instructions which are assigned to these fault states and enable successful activation of the at least one restraining means (22, 23, 31) even when fault states occur, characterized in that the output stage comprises a plurality of switching elements, the control instructions are dependent on the supply voltage, and in that, in the event of a supply voltage of between about 30 volts and about 45 volts and a short circuit between that terminal (FM, BFM) of a capacitor (CF, CBF) which is near to earth, said capacitor being connected in series with the firing pellet (ZPF, ZPBF), and the positive pole of the supply voltage or the earth terminal, at least the switching element (T1) can be driven cyclically (timing pulse T) in such a way that it is turned on in a first time interval (TI) and is turned off in a second time interval (TII), while the switching elements (T3, T4) are turned off during the first time interval (TI) and are turned off during the second time interval (TII).

11. Electronic safety device according to one of Claims 1 to 10, characterized in that the switching elements are semiconductor components.

12. Electronic safety device according to one of Claims 1 to 11, characterized in that the output stage (30, 30/1, ...30/6) comprises first switching elements (T1, T2, ...T6, T11, T12, ...T14) and second switching elements (TM1, ..., TM6) which are produced using integrated technology.

13. Electronic safety device according to Claim 12, characterized in that the first and second switching elements can assume at least two defined switching states, namely an ON state and an OFF state, and in that, in the ON state, the contact resistance of the second switching elements (TM1, ..., TM6) is significantly greater than the contact resistance of the first switching elements (T1, T2, ...T6, T11, T12, ... T14).

14. Electronic safety device according to one of Claims 12, 13, characterized in that, in the ON state, the contact resistance of the second switching elements is greater than the contact resistance of the first switching elements by a factor of 10 to 100.

15. Electronic safety device according to one of Claims 1 to 14, characterized in that a reference path comprising a series circuit formed by a capacitor (C2) and a resistor (R2) is provided for determining the contact resistance of the switching elements, the capacitor (C2) of which reference path can be charged and discharged by a corresponding switching position of the switching elements.

## Revendications

1. Installation électronique de sécurité (1) pour les passagers d'un véhicule, comprenant un capteur (200) sensible à l'accélération, un appareil de commande comportant au moins un microcalculateur (20), au moins un moyen de retenue (22, 23, 31) et au moins un étage de puissance (30) commandant l'un de ces moyens de retenue, cet étage de puissance comportant au moins une pastille d'allumage (ZPF, ZPBF),
l'installation de sécurité (1) comprenant une mémoire (202) qui contient les états de défauts de l'installation de sécurité et les indications de commande associées à ces états de défauts, permettant une activation réussie d'au moins un moyen de retenue (22, 23, 31) même lorsque se produisent des états de défauts,
caractérisée en ce que
• l'étage de puissance comprend un élément de commutation (T2), les indications de commande dépendant de la tension d'alimentation, et
• pour une tension d'alimentation comprise entre environ 30 volts et environ 45 volts, et un court-circuit entre le branchement éloigné de la masse (FP, BFP) de la pastille d'allumage (ZPF, ZPBF) et le pôle positif de la tension d'alimentation, on commande au moins en cadence (cadence d'horloge T) l'élément de commutation (T2) pour qu'il soit passant dans un premier intervalle de temps (TI) et bloqué dans un second intervalle de temps (TII).

2. Installation électronique de sécurité selon la revendication 1,
caractérisée en ce qu'
en phase de blocage (TII) de l'élément de commutation (T2), les éléments de commutation (T5, T6) sont commandés de façon à être conducteurs.

3. Installation électronique de sécurité selon l'une quelconque des revendications 1, 2,
caractérisée en ce que
les intervalles de temps (TI, TII) sont de même longueur.

4. Installation électronique de sécurité selon les revendications 1 à 3,
caractérisée en ce que
la durée de l'intervalle de temps (TI) est comprise entre 5 et 10 microsecondes, et est de préférence égale à 7 microsecondes.

5. Installation électronique de sécurité selon l'une quelconque des revendications 1 à 4,
caractérisée en ce que
pendant les intervalles de temps (TI, TII), on commande en outre les éléments de commutation (T3, T4) pour les rendre conducteurs ou bloqués.

6. Installation électronique de sécurité (1) pour les occupants d'un véhicule, comprenant un capteur (200) sensible à l'accélération, au moins un appareil de commande comprenant au moins un microcalculateur (20) avec au moins un moyen de retenue (22, 23, 31) et au moins un étage de puissance (30) qui commande le moyen de retenu, et comprend au moins une pastille d'allumage (ZPF, ZPBF), l'installation de sécurité (1) comprenant une mémoire (202) enregistrant les états de défauts de l'installation de sécurité et mémorisant des états de défauts associés aux indications de commande, et qui permet une activation réussie d'au moins un moyen de retenue (22, 23, 31) même en cas de production d'état de défauts,
caractérisée en ce que
- l'étage de puissance (30) comprend plusieurs éléments de commutation,
- les instructions de commande dépendent de la tension d'alimentation et,
- pour une tension d'alimentation comprise entre environ 24 volts et environ 30 volts et un court-circuit entre le branchement éloigné de la masse (FP, BFP) de la pastille d'allumage (ZPF, ZPBF) et le pôle positif de la tension d'alimentation, ou pour un court-circuit entre la borne éloignée de la masse (FP, BFP) de la pastille d'allumage (ZPF, ZPBF) et le branchement de masse, on commande au moins un élément de commutation (T2) pas-à-pas (cadence T) de façon qu'il soit commandé à l'état passant dans un premier intervalle de temps (TI) et qu'il soit bloqué dans un second intervalle de temps (TII) tandis qu'en phase de blocage (TII) de l'élément de commutation (T2), les éléments de commutation (T5, T6) sont commandés pour être conducteurs.

7. Installation électronique de sécurité selon la revendication 6,
caractérisée en ce que
la durée des intervalles de temps (TI, TII) est comprise entre 3 et 10 microsecondes et de préférence égale à 5 microsecondes.

8. Installation électronique de sécurité (1) pour les occupants d'un véhicule, comportant un capteur (200) sensible à l'accélération, un appareil de commande comprenant au moins un microcalculateur (20), au moins un moyen de retenue (22, 23, 31) et un étage de puissance (30) commandant ce moyen de retenue, cet étage comportant au moins une pastille d'allumage (ZPF, ZPBF) ; l'installation de sécurité comprenant des moyens de mémoire (202) qui contiennent les états d'erreurs de l'installation de sécurité et les indications de commande associées à ces états d'erreurs, et qui produisent une activation réussie d'au moins l'un des éléments de retenue (22, 23, 31) même en cas d'arrivée d'états d'erreurs
caractérisée en ce que
l'étage de puissance (30) comprend plusieurs éléments de commutation, les indications de commande sont indépendantes de la tension d'alimentation et pour une tension comprise entre environ 9 volts et environ 24 volts, et un court-circuit entre le branchement éloigné de la masse (FP, BFP) de la pastille d'allumage (ZPF, ZPBF) et le pôle positif de la tension d'alimentation des éléments de commutation (T1, T2) ou (T3, T4, T5, T6) sont commandés séparément par cadence, en mode Push/Pull (cadence T, TI, TII) de façon que dans un premier intervalle de temps (TI), les éléments de commutation (T2, T3, T4) soient conducteurs et que les éléments de commutation (T1, T5, T6) soient bloqués, tandis que dans un second intervalle de temps (TII), les éléments de commutation (T1, T5, T6) sont conducteurs et les éléments de commutation (T2, T4, T4) sont commandés pour être bloqués.

9. Installation électronique de sécurité selon la revendication 8,
caractérisée en ce que
la durée de l'intervalle de temps (TI, TII) est comprise entre 2 et 8 microsecondes et est égale de préférence à 3 microsecondes.

10. Installation électronique de sécurité (1) pour les occupants d'un véhicule, comportant un capteur (200) sensible à l'accélération, un appareil de commande comprenant au moins un microcalculateur (20), un étage de puissance (30) commandant au moins un moyen de retenue (22, 23, 31)et l'un de ces moyens de retenue qui comprend au moins une pastille d'allumage (ZPF, ZPBF), l'installation de sécurité (1) comprenant une mémoire (202) enregistrant les états de défauts de l'installation de sécurité, les indications de commande associées à ces états de défauts permettant une activation réussie d'au moins l'un des moyens de retenue (22, 23, 31) même lorsque se produisent des états de défauts,
caractérisée en ce que
• l'étage de puissance comporte plusieurs éléments de commutation et les indications de commande dépendent de la tension d'alimentation, et
• pour une tension comprise entre environ 30 volts et environ 45 volts et un court-circuit entre le branchement proche de la masse (FM, BFM) d'un condensateur (CF, CBF) branché en série sur la pastille d'allumage (ZPF, ZPBF) et le potentiel de la tension d'alimentation ou la borne de masse, au moins l'élément de commutation (T1) est commandé par cadence (cadence T) pour que, dans un premier intervalle de temps (TI), il soit commandé de façon à être conducteur et que, dans un second intervalle de temps (TII), il soit bloqué pendant que les éléments de commutation (T3, T4) sont bloqués pendant le premier intervalle de temps (TI) tandis qu'ils sont débloqués pendant le second intervalle de temps (TII).

11. Installation électronique de sécurité selon l'une quelconque des revendications 1 à 10,
caractérisée en ce que
les éléments de commutation sont des composants semi-conducteurs.

12. Installation électronique de sécurité selon l'une quelconque des revendications 1 à 11,
caractérisée en ce que
les étages de puissance (30, 30/1 ... 30/6) comprennent des premiers éléments de commutation (T1, T2 ... T6 ; T11, T12 ... T14) et des seconds éléments de commutation (TM1 ... TM6) fabriqués en technique intégrée.

13. Installation électronique de sécurité selon la revendication 12,
caractérisée en ce que
les premiers seconds éléments de commutation peuvent prendre au moins deux états de commutation déterminés à savoir un état de branchement et un état hors service, et en ce que ,pour le premier état, la résistance de passage des seconds éléments de commutation (TM1 ... TM6) est considérablement plus grande que la résistance de passage des premiers éléments de commutation (T1, T2 ... T6 ... T11, T12 ... T14).

14. Installation électronique de sécurité selon l'une quelconque des revendications 12 et 13,
caractérisée en ce qu'
à l'état branché la résistance de passage des premiers éléments de commutation est supérieure d'un coefficient 10 à 100 à la résistance de passage des premiers éléments de commutation.

15. Installation électronique de sécurité selon l'une quelconque des revendications 1 à 14,
caractérisée en ce que
pour déterminer la résistance de passage des éléments de commutation, on prévoit une branche de référence formée du montage en série d'un condensateur (C2) et d'une résistance (R2), le condensateur (C2) pouvant se charger et se décharger à travers un chemin de commutation approprié de l'élément de commutation.
